# EUROPEAN PATENT APPLICATION

(11) **EP 4 848 283 A1**
(43) Date of publication of application: **02.12.2026**
(21) Application number: 25896500.3
(22) Date of filing: 17.03.2025
(51) Int. Cl.: G11C 5/06

(54) **SEMICONDUCTOR DEVICE AND OPERATING METHOD THEREOF, AND SYSTEM**

(30) Priority: 27.11.2024 CN 202411722797
(71) Applicant: CCSH Corporation, Wuhan, Hubei 430000 (CN)
(72) Inventor: LI, Xinran, Wuhan, Hubei 430000 (CN); ZHAO, Xiangnan, Wuhan, Hubei 430000 (CN); XU, Feng, Wuhan, Hubei 430000 (CN); CHEN, Wenping, Wuhan, Hubei 430000 (CN); MIN, Yuanyuan, Wuhan, Hubei 430000 (CN); LI, Da, Wuhan, Hubei 430000 (CN); JIN, Lei, Wuhan, Hubei 430000 (CN); HUO, ZongLiang, Wuhan, Hubei 430000 (CN)
(74) Representative: Lippert Stachow Patentanwälte Rechtsanwälte
(86) International application number: PCT/CN2025/082919
(87) International publication number: WO 2026/113193

(57) **Abstract**

The present disclosure provides a semiconductor device and an operating method thereof, and a system. The semiconductor device includes a memory cell array, word lines coupled to the memory cell array, and a peripheral circuit coupled to the word lines, wherein the peripheral circuit is configured to: perform a first program operation on a target memory cell set of a plurality of memory cell sets coupled to a selected word line, wherein the first program operation includes a plurality of first program cycles; and the target memory cell set includes a plurality of memory cells whose threshold voltages are to be programmed into a target threshold voltage distribution; and perform a second program operation on the target memory cell set, wherein the second program operation includes at least one second program cycle, the second program cycle includes a verify phase and a program phase after the verify phase.

## Description

### FIELD OF TECHNOLOGY

The present disclosure relates to the field of semiconductor technologies, and in particular, to a semiconductor device and an operating method thereof, and a system.

### BACKGROUND

With the continuous growth of AIGC (Artificial Intelligence Generated Content) model parameters, the traditional von Neumann's architecture is facing the problems of "memory wall" and "power consumption wall", and the bandwidth between CPU (Central Processing Unit) and memory has become a bottleneck restricting the performance of AI (Artificial Intelligence) chips. Inspired by the working mode characteristics of the human brain, the architecture of compute-in-memory has been vigorously developed in recent years. By embedding computing functions in memory, it avoids the back and forth transfer of data, reduces the impact of the memory wall and the power consumption wall, and it is expected to build a computing system with high computing power, high bandwidth, and high energy efficiency. Improving the accuracy of in-memory operations and the accuracy of data reading and writing of the memory is a long-term research focus in this field.

### SUMMARY

The examples of the present disclosure provide a semiconductor device and an operating method thereof, and a system.

According to a first aspect, an example of the present disclosure provides a semiconductor device, comprising: a memory cell array, word lines coupled to the memory cell array, and a peripheral circuit coupled to the word lines, wherein the peripheral circuit is configured to:
perform a first program operation on a target memory cell set of a plurality of memory cell sets coupled to a selected word line, wherein the first program operation comprises a plurality of first program cycles; and the target memory cell set comprises a plurality of memory cells whose threshold voltages are to be programmed into a target threshold voltage distribution corresponding to one of a plurality of states; and
perform a second program operation on the target memory cell set, wherein the second program operation comprises at least one second program cycle, the second program cycle comprises a verify phase and a program phase after the verify phase, wherein at least a portion of the target memory cell set are verified during the verify phase of the second program cycle, and memory cells failing to be verified are programmed during the program phase of the second program cycle.

According to a second aspect, an example of the present disclosure provides another semiconductor device, comprising: a memory cell array, word lines coupled to the memory cell array, and a peripheral circuit coupled to the word lines, wherein the peripheral circuit is configured to:
perform a first program operation on at least a memory cell set corresponding to a programmed state of a plurality of memory cell sets coupled to a selected word line; wherein the memory cell set comprises a plurality of memory cells whose threshold voltages are to be programmed into a target threshold voltage distribution corresponding to a same programmed state or an erased state; and
perform a second program operation on the memory cell set corresponding to the erased state, wherein the second program operation comprises: at least one second program cycle, the second program cycle comprises a verify phase and a program phase after the verify phase, wherein at least a portion of the memory cell set corresponding to the erased state are verified during the verify phase of the second program cycle, and memory cells failing to be verified are programmed during the program phase of the second program cycle.

According to a third aspect, an example of the present disclosure provides a system, comprising: one or more semiconductor devices according to any one of the first aspect and the second aspect of the present disclosure; and
a memory controller coupled to the semiconductor device and configured to control the semiconductor device.

According to a fourth aspect, an example of the present disclosure provides an operating method of a semiconductor device, comprising:
performing a first program operation on a target memory cell set of a plurality of memory cell sets coupled to a selected word line, wherein the first program operation comprises a plurality of first program cycles; and the target memory cell set comprises a plurality of memory cells whose threshold voltages are to be programmed into a target threshold voltage distribution corresponding to one of a plurality of states; and
performing a second program operation on the target memory cell set, wherein the second program operation comprises at least one second program cycle, the second program cycle comprises a verify phase and a program phase after the verify phase, wherein at least a portion of the target memory cell set are verified during the verify phase of the second program cycle, and memory cells failing to be verified are programmed during the program phase of the second program cycle.

According to a fifth aspect, an example of the present disclosure provides an operating method of a semiconductor device, comprising:
performing a first program operation on at least a memory cell set corresponding to a programmed state of a plurality of memory cell sets coupled to a selected word line; wherein the memory cell set comprises a plurality of memory cells whose threshold voltages are to be programmed into a target threshold voltage distribution corresponding to a same programmed state or an erased state; and
performing a second program operation on the memory cell set corresponding to the erased state, wherein the second program operation comprises: at least one second program cycle, the second program cycle comprises a verify phase and a program phase after the verify phase, wherein at least a portion of the memory cell set corresponding to the erased state are verified during the verify phase of the second program cycle, and memory cells failing to be verified are programmed during the program phase of the second program cycle.

In the technical solution according to the present disclosure, in the write operation phase of the data storage, the target memory cell set may be the memory cell set corresponding to the programmed state, by performing the first program operation on the target memory cell set, the threshold voltage of the target memory cell set may form an intermediate threshold voltage distribution. In the first second program cycle of the second program operation, verify is first performed to select a portion of memory cells near the low tail from the intermediate threshold voltage distribution, and then the selected memory cells are programmed, while other memory cells in the intermediate threshold voltage distribution are not programmed. By appropriately increasing the threshold voltage of the memory cell in the low tail, the threshold voltage distribution can be effectively narrowed, so that the accuracy of data read-write is improved, and the influence of the IVS effect on the accuracy of data storage can be effectively reduced.

During the write operation phase of the in-memory operation, the target memory cell set may be the memory cell set corresponding to the erased state, and after the first program operation and the second program operation are performed on the target memory cell set, the threshold voltage distribution corresponding to the erased state may be narrowed, so that the magnitude of each current in the operation phase is narrowed, thereby improving the accuracy of the in-memory operation.

### BRIEF DESCRIPTION OF THE DRAWINGS

FIG. 1 is a schematic diagram of a semiconductor device comprising a peripheral circuit according to an example of the present disclosure.
FIG. 2a is a first schematic diagram of a semiconductor device comprising a peripheral circuit and a memory cell array according to an example of the present disclosure.
FIG. 2b is a second schematic diagram of a semiconductor device comprising a peripheral circuit and a memory cell array according to an example of the present disclosure.
FIG. 3 is a schematic diagram of a first program operation and a second program operation performed by a semiconductor device according to an example of the present disclosure.
FIG. 4 is a schematic diagram of a threshold voltage change of a memory cell coupled to a selected word line in a write operation phase of data storage according to an example of the present disclosure.
FIG. 5 is a first schematic diagram of a threshold voltage change of a memory cell set corresponding to a programmed state according to an example of the present disclosure.
FIG. 6 is a second schematic diagram of a threshold voltage change of a memory cell corresponding to a programmed state according to an example of the present disclosure.
FIG. 7 is a schematic diagram of inputting an input voltage into a memory block by a top select line according to an example of the present disclosure.
FIG. 8 is a schematic diagram of performing an in-memory operation on a memory cell array comprising a single level cell according to an example of the present disclosure.
FIG. 9 is a first schematic diagram of threshold voltage distribution of a memory cell coupled to a selected word line in a write operation phase of an in-memory operation according to an example of the present disclosure.
FIG. 10 is a second schematic diagram of threshold voltage distribution of a memory cell coupled to a selected word line in a write operation phase of an in-memory operation according to an example of the present disclosure.
FIG. 11 is a third schematic diagram of threshold voltage distribution of a memory cell coupled to a selected word line in a write operation phase of an in-memory operation according to an example of the present disclosure.
FIG. 12 is a first schematic diagram of a first program operation according to an example of the present disclosure.
FIG. 13 is a second schematic diagram of a first program operation according to an example of the present disclosure.
FIG. 14 is a schematic diagram of threshold voltage distribution according to an example of the present disclosure.
FIG. 15 is a first schematic diagram of a second program operation according to an example of the present disclosure.
FIG. 16 is a second schematic diagram of a second program operation according to an example of the present disclosure.
FIG. 17 is a third schematic diagram of a second program operation according to an example of the present disclosure.
FIG. 18 is a schematic flowchart of an operating method of a semiconductor device according to an example of the present disclosure.
FIG. 19 is a schematic flowchart of another operating method of a semiconductor device according to an example of the present disclosure.
FIG. 20 is a first schematic composition diagram of a system according to an example of the present disclosure.
FIG. 21 is a second schematic composition diagram of a system according to an example of the present disclosure.
FIG. 22 is a schematic diagram of an exemplary memory card having a memory system according to an example of the present disclosure.
FIG. 23 is a schematic diagram of an exemplary solid state disk having a memory system according to an example of the present disclosure.

### DETAILED DESCRIPTION

Example aspects disclosed in the present disclosure will be described in more detail below with reference to the accompanying drawings. Although example aspects of the present disclosure are shown in the accompanying drawings, it should be understood that the present disclosure may be implemented in various forms and should not be limited to the aspects set forth herein. Rather, these aspects are provided so that the present disclosure can be more thoroughly understood and the scope disclosed in the present disclosure can be fully conveyed to those skilled in the art.

In the following description, numerous details are given in order to provide a more thorough understanding of the present disclosure. However, it will be apparent to one skilled in the art that, the present disclosure may be practiced without one or more of these details. In other examples, in order to avoid confusion with the present disclosure, some technical features known in the art are not described; that is, not all features of the actual examples are described here, and well-known functions and structures are not described in detail.

In the drawings, like reference numerals refer to like elements throughout.

It should be understood that spatial relation terms such as "beneath," "below," "lower," "under", "above," "upper," etc., may be used herein for ease of description to describe the relationship between one element or feature and other elements or features shown in the figures. It should be appreciated that, in addition to the orientations shown in the figures, the spatial-relation terms intent to also comprise different orientations of the devices in use and operation. For example, if the devices in the figures are flipped, then described as "below" or "under" or "beneath" other elements or features will be oriented "on" other elements or features. Thus, the example terms "below" and "beneath" may comprise both upper and lower orientations. The devices may be additionally oriented (rotated 90 degrees or other orientations) and the spatial description terminology used herein is interpreted accordingly.

A term used herein is for the purpose of describing a particular example only and is not to be considered as limitation of the present disclosure. As used herein, "a", "an" and "said/the" in the singular form are intended to comprise the plural forms as well, unless the context indicated clearly otherwise. It should also be understood that the terms at least one of "consists of" or "comprising", when used in this description, identify the presence of at least one of stated features, integers, steps, operations, elements or components, but do not exclude the presence and addition of at least one of one or more other features, integers, steps, operations, elements, components or groups. As used herein, the term "at least one of" comprises any and all combinations of the related listed items.

In the classic von Neumann's computing architecture, the memory is separate from the processor, and the data is transferred between the memory and the processor through the data bus. When executing a command, the processor first reads the data from the memory, and then writes the updated data back into the memory, and the frequent data migration leads to huge power consumption and time overheads; in addition, because the memory bandwidth is limited, the processing speed of the processor is limited by the access speed of the memory, which greatly affects the calculation performance. With the rise of applications such as big data and artificial intelligence, the processing of massive data has made the bottleneck of von Neumann's computing architecture increasingly prominent. In order to solve the bottleneck of the classic von Neumann's computing architecture, the compute-in-memory chip architecture emerges, and the basic idea is to embed a calculation function in the memory and directly use the memory to perform logic calculation, thereby reducing the amount of data transmission and the transmission distance between the memory and the processor, reducing the power consumption while improving the calculation performance, so that a computing system with high computing power, high bandwidth and high energy efficiency is expected to be constructed.

The compute-in-memory chip comprises, but is not limited to, Static Random Access Memory (SRAM), NAND flash memory, and Dynamic Random Access Memory (DRAM). NAND flash memory is a non-volatile memory and has a large capacity, thus becoming a widely studied object in the compute-in-memory chip. The contents of the NAND flash memory will be introduced below.

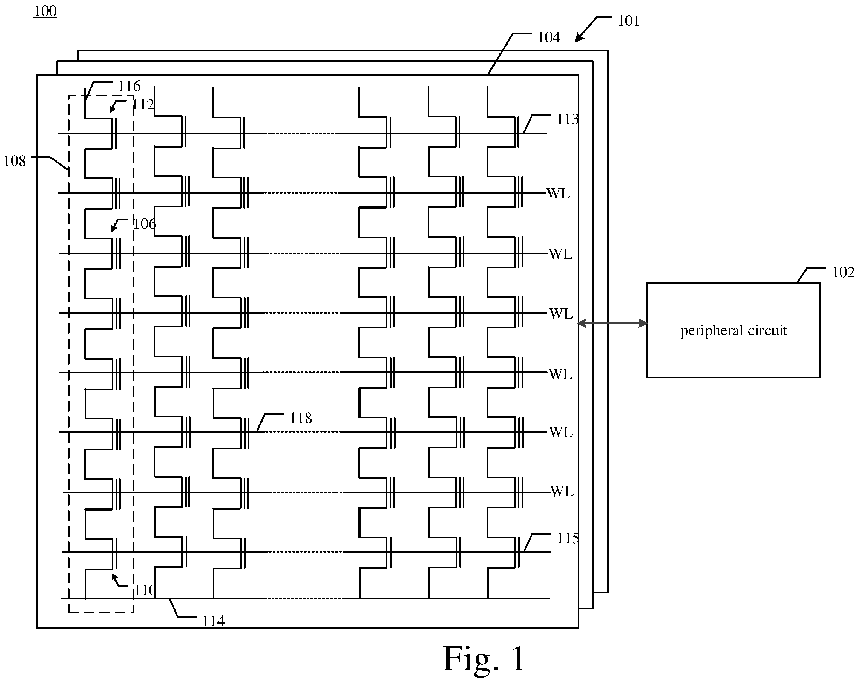

FIG. 1 is a schematic diagram of a semiconductor device comprising a peripheral circuit according to an example of the present disclosure. The semiconductor device 100 may comprise a memory cell array 101 and peripheral circuit 102 coupled to the memory cell array 101. Taking the memory cell array 101 being a three-dimensional NAND type memory array as an example for description, where the memory cell 106 is a NAND memory cell, the memory cell 106 is provided in the form of an array of memory strings (also referred to as memory cell strings) 108, and each memory string 108 extends vertically. In some implementations, each memory string 108 comprises a plurality of memory cells 106 coupled in series and stacked vertically. Each memory cell 106 may maintain a continuous analog value, e.g., voltage or charge, depending on the number of electrons captured within the area of the memory cell 106. Each memory cell 106 may be a floating gate type memory cell comprising a floating gate transistor, or a charge trapping type memory cell comprising a charge trapping transistor.

In some implementations, each memory cell 106 is a single level cell (SLC) having two possible memory states and thus may store one bit of data. For example, the first memory state "0" may correspond to a first voltage range and the second memory state "1" may correspond to a second voltage range. In some implementations, each memory cell 106 is a multi-level cell capable of storing more than a single bit of data in four or more memory states, e.g., a multi-level cell (MLC) storing two bits per cell, a triple level cell (TLC) storing three bits per cell, or a quad-level cell (QLC) storing four bits per cell.

As shown in FIG. 1, each memory string 108 may comprise a bottom select gate (BSG) 110 at its source terminal and a top select gate (TSG) 112 at its drain terminal. The bottom select gate 110 and the top select gate 112 may be configured to activate the selected memory string 108 during read and program operations. In some implementations, the sources of the memory strings 108 in the same memory block 104 may be coupled through a common source line (CSL) 114. In other words, all the memory strings 108 in the same memory block 104 have a common source (ACS). According to some implementations, the top select gate 112 of each memory string 108 is coupled to a respective bit line 116 from which data may be read or written. A top select gate 112 of each memory string 108 is coupled to a respective top select line (TSL) 113, and a bottom select gate 110 of each memory string 108 is coupled to a respective bottom select line (BSL) 115. In some implementations, each memory string 108 is configured to be selected or deselected by applying a select voltage (e.g., a voltage higher than a threshold voltage of the top select gate 112) or a deselect voltage (e.g., 0V) to the respective top select gate 112 through one or more top select lines 113 and / or by applying a select voltage (e.g., a voltage above a threshold voltage of the bottom select gate 110) or a deselect voltage (e.g., 0V) to the respective bottom select gate 110 through one or more bottom select lines (BSL) 115. Memory cells 106 of adjacent memory strings 108 may be coupled via word lines 118 that select which row of memory cells 106 is affected by read and program operations.

With continued reference to FIG. 1, the peripheral circuit 102 may be coupled to the memory cell array 101 through bit lines 116, word lines 118, source lines 114, bottom select lines 115, and top select lines 113. The peripheral circuit 102 may comprise any suitable analog, digital, and mixed-signal circuit for facilitating operation of the memory cell array 101 by applying voltage signals and / or current signals to and sensing voltage signals and / or current signals from each of the memory cells 106 via bit lines 116, word lines 118, source lines 114, bottom select lines 115, and top select lines 113. Peripheral circuit 102 may comprise various types of peripheral circuit formed using metal-oxide-semiconductor technology.

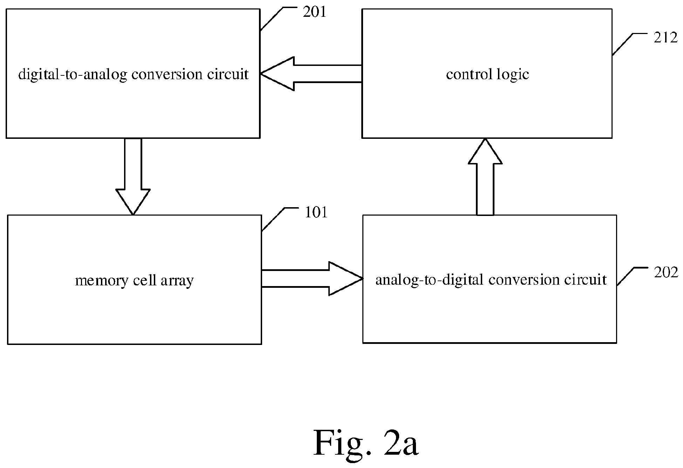

FIG. 2a is a first schematic diagram of a semiconductor device comprising a peripheral circuit and a memory cell array according to an example of the present disclosure. Referring to FIG. 1 and FIG. 2a, the peripheral circuit 102 may comprise a control logic 212, a digital-to-analog conversion circuit 201 coupled to the control logic 212 and the memory cell array 101, and an analog-to-digital conversion circuit 202 coupled to the memory cell array 101 and the control logic 212. During an in-memory operation phase by using the semiconductor device, the digital-to-analog conversion circuit 201 may convert the digital signal into a voltage signal required by the memory cell array 101 in the compute-in-memory chip. The analog-to-digital conversion circuit 202 may convert the current signal output by the memory cell array 101 into a digital signal. The control logic 212 may be coupled to the peripheral circuit and configured to control operation of the peripheral circuit. The control logic 212 may be further configured to receive input data sent by the controller, and send the operation result to the controller.

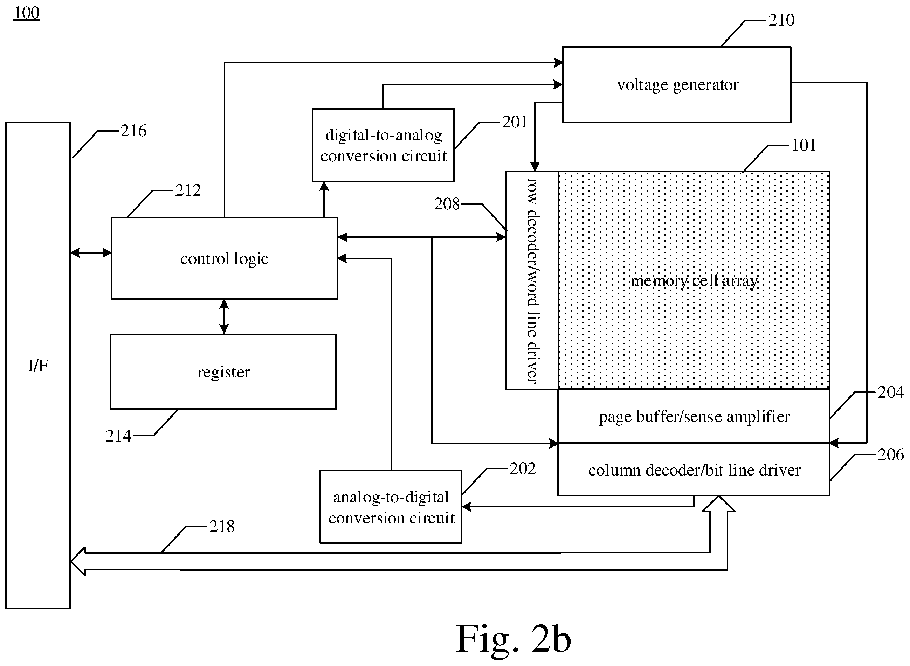

FIG. 2b is a second schematic diagram of a semiconductor device comprising a peripheral circuit and a memory cell array according to an example of the present disclosure. In addition to the circuit structure shown in FIG. 2a, as shown in FIG. 2b, the peripheral circuit may further comprise a page buffer / sense amplifier 204, a column decoder / bit line (BL) driver 206, a row decoder / word line (WL) driver 208, a voltage generator 210, a register 214, an interface 216, and a data bus 218. It should be understood that in some examples, additional peripheral circuits not shown in FIG. 2a and FIG. 2b may also be comprised.

The page buffer / sense amplifier 204 may be configured to read data from and program (write) data to the memory cell array 101 according to control signals from the control logic 212. In an example, the page buffer / sense amplifier 204 may store a page of program data to be programmed into one page of the memory cell array 101. In another example, the page buffer / sense amplifier 204 may perform a program verify operation to ensure that the data has been properly programmed into the memory cell 106 coupled to the selected word line 118. In yet another example, the page buffer / sense amplifier 204 may also sense a low power signal from the bit line 116 representing a data bit stored in the memory cell 106, and amplify the small voltage swing to an identifiable logic level in a read operation. Column decoder / bit line driver 206 may be configured to be controlled by control logic 212 and select one or more memory strings 108 by applying a bit line voltage generated from voltage generator 210.

The row decoder / word line driver 208 may be configured to be controlled by the control logic 212 and select / deselect the memory block 104 of the memory cell array 101 and select / deselect the word line 118 of the memory block 104. The row decoder / word line driver 208 may also be configured to drive the word line 118 using the word line voltage generated from the voltage generator 210. In some implementations, row decoder / word line driver 208 may also select / deselect and drive BSL115 and TSL113. As described in detail below, the row decoder / word line driver 208 is configured to perform a program operation on the memory cells 306 coupled to the selected word line (s) 118. The voltage generator 210 may be configured to be controlled by the control logic 212 and generate word line voltages (e.g., read voltages, program voltages, pass voltages, select voltages, program verify voltages, etc., input voltages), bit line voltages, and source line voltages to be supplied to the memory array 301.

Registers 214 may be coupled to control logic 212 and comprise status registers, command registers, and address registers for storing status information, command operation codes (OP codes), and command addresses for controlling operation of each peripheral circuit. The interface 216 may be coupled to the control logic 212 and act as a control buffer to buffer control commands received from the host-side device and relay it to the control logic 212 and buffer status information received from the control logic 212 and relay it to the host-side device. Interface 216 may also be coupled to column decoder / bit line driver 206 via data bus 218 and act as a data I / O interface and a data buffer to buffer data and relay it to the memory cell array 101, or relay or buffer data from the memory cell array 101.

In some examples, as shown in FIG. 2b, the digital-to-analog conversion circuit 201 may be connected to the control logic 212 and the voltage generator 210, and the analog-to-digital conversion circuit 202 may be connected to the control logic 212 and the column decoder / bit line driver 206. In the operation phase using the three-dimensional NAND type memory, the control logic may receive input data sent by the controller, the digital-to-analog conversion circuit converts the input data to a voltage signal that needs to be applied on the word line or bit line, the voltage generator generates a corresponding voltage that needs to be applied on the word line or the bit line, the row decoder / word line driver is configured to drive the selected word line using the word line voltage generated from the voltage generator, or the column decoder / bit line driver is configured to drive the selected bit line using the bit line voltage generated from the voltage generator. The analog operation result obtained after the operation is transmitted to the analog-to-digital conversion circuit through the page buffer and the column decoder, the analog operation result is converted into a digital operation result through the analog-to-digital conversion circuit, and the final digital operation result is transmitted to the control logic.

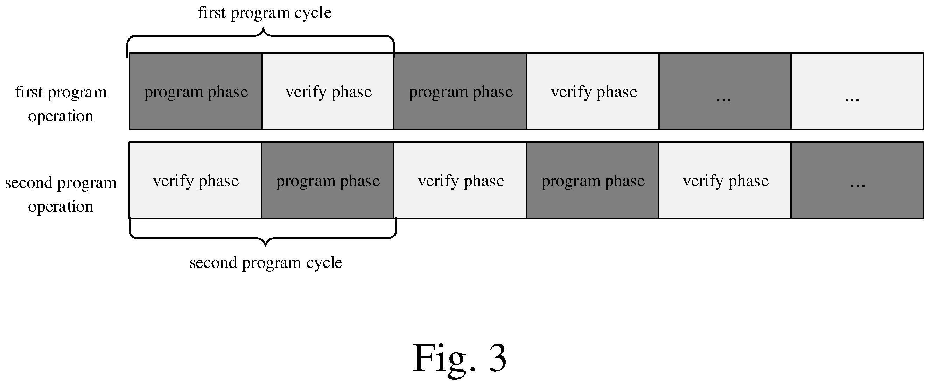

In the memory supporting compute-in-memory, narrowing the threshold voltage distribution can improve the accuracy of reading and writing data, and can also improve the accuracy and computing power of memory-compute. The example of the present disclosure provides a semiconductor device, which can achieve high-accuracy program and narrow threshold voltage distribution. FIG. 3 is a schematic diagram of a first program operation and a second program operation performed by a semiconductor device according to an example of the present disclosure. The semiconductor device comprises a memory cell array, word lines coupled to the memory cell array, and a peripheral circuit coupled to the word lines, and as shown in FIG. 3, the peripheral circuit is configured to:
perform a first program operation on a target memory cell set of a plurality of memory cell sets coupled to a selected word line, where the first program operation comprises a plurality of first program cycles; and the target memory cell set comprises a plurality of memory cells whose threshold voltages are to be programmed into a target threshold voltage distribution corresponding to one of a plurality of states; and
perform a second program operation on the target memory cell set, where the second program operation comprises at least one second program cycle, the second program cycle comprises a verify phase and a program phase after the verify phase, where at least a portion of the target memory cell set are verified during the verify phase of the second program cycle, and memory cells failed in the verification are programmed during the program phase of the second program cycle.

For example, in the verify phase of the first second program cycle, the target memory cell set (that is, all memory cells in the target memory cell set) is verified. At least a portion of the target memory cell set are verified during the verify phase of each second program cycle except the first second program cycle. At the program phase of each second program cycle, memory cells failed in the verification during the verify phase in the same second program cycle are programmed.

The memory cell array and the peripheral circuit may be the memory cell array 101 and the peripheral circuit 102 shown in any one of FIGS. 1 to 2b. The word lines may be the word lines 118 shown in FIG. 1.

In the examples of the present disclosure, the memory cell may be a single-level cell SLC having two possible memory states, and the two memory states are an erased state (also referred to as an erased status) E and a programmed state (also referred to as a programmed status) P, respectively. Correspondingly, the plurality of memory cells coupled to the selected word line may be divided into two memory cell sets A, B. The data stored in all the memory cells in one memory cell set is the same, that is, the threshold voltages of all memory cells in one memory cell set will be in the target threshold voltage distribution corresponding to the same state. Different memory cell sets store different data, that is, different memory cell sets correspond to different target threshold distributions. For example, the memory cells in the memory cell set A each stores data 0, and the memory cells in the memory cell set A will be in the target threshold voltage distribution corresponding to the erased state. The memory cells in the memory cell set B each stores data 1, and the memory cells in the memory cell set B will be programmed into the target threshold voltage distribution corresponding to the programmed state. The target memory cell set is any one of a plurality of memory cell sets. That is, the target memory cell set may be a memory cell set A or a memory cell set B.

It should be understood that the memory cells in the memory cell set are not necessarily adjacent or continuously distributed. Whether each memory cell on one word line is to store data 0 or data 1 is determined based on the written data, and typically multiple memory cells that are to store the same data are not continuously distributed.

In addition, the memory cell may also be a multi-level cell having more than two possible memory states. For example, the memory cell may be a multi-level cell MLC having four possible memory states, that are erased state E and programmed states P1, P2, and P3, respectively. Correspondingly, the plurality of memory cells coupled to the selected word line may be divided into four memory cell sets A, B, C, D at most. The threshold voltages of all the memory cells in the memory cell set A are to be in the target threshold voltage distribution corresponding to the erased state E, the threshold voltages of all the memory cells in the memory cell set B are to be programmed into the target threshold distribution corresponding to the P1 state, the threshold voltages of all the memory cells in the memory cell set C are to be programmed into the target threshold distribution corresponding to the P2 state, and the threshold voltages of all the memory cells in the memory cell set D are to be programmed into the target threshold distribution corresponding to the P3 state. The target memory cell set is any one of a plurality of memory cell sets. That is, the target memory cell set may be a memory cell set A, may be a memory cell set B, may be a memory cell set C, or may be a memory cell set D.

For example, the memory cell may also be a triple-level cell TLC with eight possible memory states. Correspondingly. The plurality of memory cells coupled to the selected word line may be divided up to eight memory cell sets at most, and the target memory cell set is any one of eight memory cell sets. The memory cell may further have more memory states, the plurality of memory cells coupled to the selected word line may be divided up to the same number of memory cell sets as the plurality of memory states, and the target memory cell set is any one of the plurality of memory cell sets.

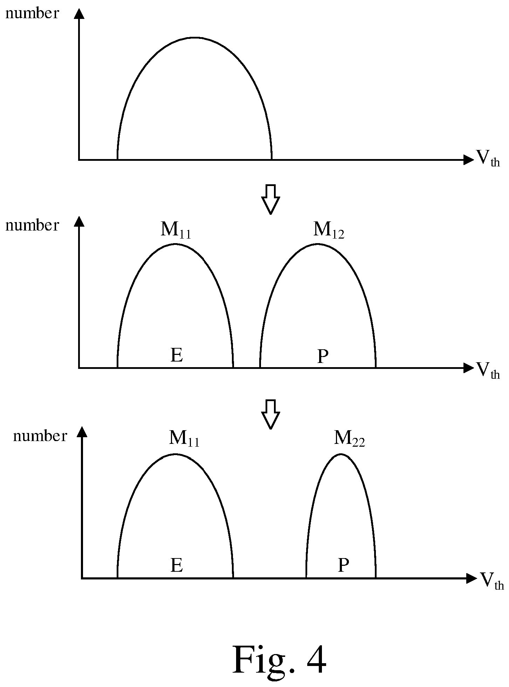

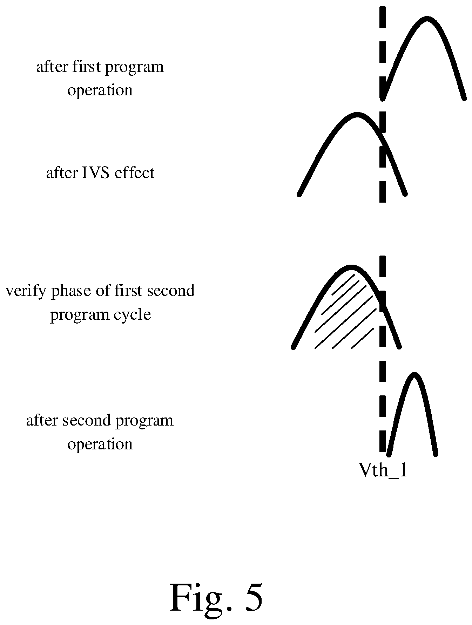

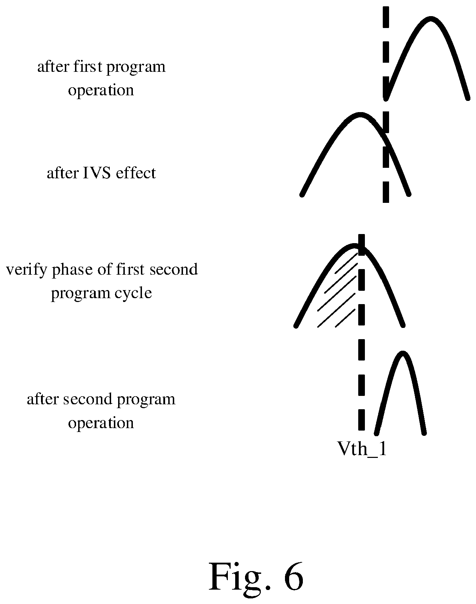

The present disclosure takes a memory cell having two possible memory states, namely an erased state E and a programmed state P, as an example to illustrate. FIG. 4 is a schematic diagram of a threshold voltage change of a memory cell coupled to a selected word line in a write operation phase of data storage according to an example of the present disclosure, wherein the ordinate is the number of memory cells, and the abscissa is the threshold voltage Vth. FIG. 5 is a first schematic diagram of a threshold voltage change of a memory cell set corresponding to a programmed state according to an example of the present disclosure, and FIG. 6 is a second schematic diagram of a threshold voltage change of a memory cell corresponding to a programmed state according to an example of the present disclosure. A program method according to an example of the present disclosure is described in detail below with reference to FIG. 4 to FIG. 6.

The memory according to the examples of the present disclosure may support data storage and in-memory operations. In some examples, the target memory cell set is a memory cell set corresponding to the programmed state P when the memory performs a write operation phase of the data storage. The first program operation is also referred to as a coarse program operation, which may program the threshold voltage of the memory cell into the intermediate threshold voltage distribution.

There is only one programmed state P for a single-level cell. As shown in FIG. 4, the first program operation may be performed on only the memory cell set B corresponding to the programmed state P, so that the threshold voltages of the memory cells in the memory cell set B forms the intermediate threshold voltage distribution M₁₂ in FIG. 4. The threshold voltages of the memory cells in the unprogrammed memory cell set A form the intermediate threshold voltage distribution M₁₁ .

It should be noted that, there are a plurality of programmed states for the multi-level cell, and then the first program operation may be performed on the memory cell sets corresponding to all the programmed states simultaneously. For example, the MLC has 3 programmed states, the first program operation may be performed on the memory cell sets corresponding to the three programmed states simultaneously, and three intermediate threshold voltage distributions are formed after the first program operation, while the memory cell sets corresponding to the unprogrammed erased state also form an intermediate threshold voltage distribution.

Referring to FIG. 5, taking the memory cell set corresponding to one programmed state P as an example, after the first program operation, due to an initial voltage shift (IVS) effect, the threshold voltages of some memory cells in the memory cell set decrease, and the threshold voltages of the memory cells may decrease to different extents, which causes the threshold voltage distribution corresponding to the programmed state to be widened, and moving to a direction of low threshold voltage (that is, moves to the left in FIG. 5).

Based on this, the examples of the present disclosure propose to verify the memory cell set corresponding to the programmed state P in the first second program cycle of the second program operation, select the memory cell failing to be verified, and then program only the memory cells failing to be verified in the program phase of the first second program cycle.

Here, the failing to be verified means that the threshold voltage of the memory cell is less than the first preset threshold voltage Vth_1, and the first preset threshold voltage Vth_1 is related to the target threshold voltage distribution corresponding to the target memory cell set.

For example, the process of verifying the memory cell set corresponding to the programmed state in the first second program cycle may be implemented by applying a verify pulse on the selected word line, sensing, by the page buffer, the voltage change on the bit line coupled to each memory cell in the memory cell set corresponding to the programmed state P, and determining whether the verification passes based on the voltage change on the bit line.

The voltage magnitude of the verify pulse and the sensing time are related to the position of the first preset threshold voltage Vth _ 1, and the memory cell with the threshold voltage less than the first preset threshold voltage Vth _ 1 can be selected by controlling the voltage magnitude of the verify pulse and the sensing time.

The first preset threshold voltage Vth _ 1 is related to the intermediate threshold voltage distribution after the IVS. The first preset threshold voltage is in the intermediate threshold voltage distribution after the IVS, so as to select some memory cells from the intermediate threshold voltage distribution after the IVS to program again. The position of the first preset threshold voltage Vth _ 1 in the intermediate threshold voltage distribution after the IVS is not limited in this example, that is, the number of the memory cells failing to be verified is not limited, and in practical applications, a proper number of memory cells failing to be verified may be selected according to parameters such as the intermediate threshold voltage distribution after IVS, the target threshold voltage distribution, the number of program operations, the program voltage and the verify voltage in the next program operation, and the like.

The first preset threshold voltage Vth _ 1 is related to the target threshold voltage distribution, which means that the first preset threshold voltage Vth _ 1 is related to the intermediate threshold voltage distribution after the IVS, and the intermediate threshold voltage distribution after the IVS is related to the target threshold voltage distribution. The first preset threshold voltage Vth _ 1 may be less than or equal to the lower limit value of the target threshold voltage distribution.

In addition, the first preset threshold voltage Vth _ 1 may be less than, equal to, or greater than the lower limit value of the intermediate threshold voltage distribution after the first program operation. FIG. 5 shows a case where the first preset threshold voltage Vth _ 1 is equal to the lower limit value of the intermediate threshold voltage distribution after the first program operation. FIG. 6 shows a case where the first preset threshold voltage is less than the lower limit value of the intermediate threshold voltage distribution after the first program operation. It should be understood that in different implementations, the intermediate threshold voltage distribution after the first program operation may be lower than, equal to, or higher than the target threshold voltage distribution for different purposes. For example, as shown in FIG. 5, if the lower limit value of the intermediate threshold voltage distribution after the first program operation is equal to the lower limit value of the target threshold voltage distribution, the IVS effect causes the intermediate threshold voltage distribution to shift left, and the first preset threshold voltage Vth _ 1 used in the second program operation may be the lower limit value of the target threshold voltage distribution, and in this case, the first preset threshold voltage Vth _ 1 is equal to the lower limit value of the intermediate threshold voltage distribution after the first program operation. As another example, as shown in FIG. 6, if the intermediate threshold voltage distribution after the first program operation is higher than the target threshold voltage distribution and the first preset threshold voltage Vth _ 1 used in the second program operation is the lower limit value of the target threshold voltage distribution with the consideration of IVS effect, the first preset threshold voltage Vth _ 1 is less than the lower limit value of the intermediate threshold voltage distribution after the first program operation. As another example, the first preset threshold voltage Vth _ 1 may be any value between the lower limit value of the target threshold voltage distribution and the lower limit value of the intermediate threshold voltage distribution after the IVS, and the purpose is to make the threshold voltage distribution closer to the target threshold voltage distribution after the selected memory cell failing to be verified are programmed.

In general, the second program operation may set the first preset threshold voltage Vth _ 1 for the purpose of narrowing the threshold voltage distribution step by step, and programming the threshold voltage distribution of the memory cell set to the target threshold voltage distribution in the following program operation. The second program operation may also set the first preset threshold voltage Vth _ 1 for the purpose of programming the threshold voltage distribution of the memory cell set to the target threshold voltage distribution.

As shown in FIG. 5 and FIG. 6, in the first second program cycle of the second program operation, after programming the selected memory cell failing to be verified, the threshold voltage of the memory cell failing to be verified moves to the direction of the threshold voltage increase (i.e., to the right in the figure), and the threshold voltage distribution of the memory cell set can be narrowed. In the other second program cycles after the first second program cycle, only the memory cells failing to be verified are programmed, eventually making the threshold voltage distribution of the programmed state after the second program operation to be narrower than the threshold voltage distribution after the first program operation. For example, the second program operation is also referred to as a fine program operation.

For example, as shown in FIG. 4, in the write operation phase of the data storage, the memory cell set corresponding to the erased state E may not be programmed, and the threshold voltage of the memory cell set corresponding to the erased state E after the second program operation still forms the intermediate threshold voltage distribution M₁₁ .

For example, the second program operation may be performed on the memory cell set corresponding to each programmed state P. In some examples, the second program operation may also be performed simultaneously on the memory cell sets corresponding to the plurality of programmed states P.

In the examples of the present disclosure, in the write operation phase of the data storage, the first program operation is performed on the target memory cell set, so that the threshold voltage of the target memory cell set forms an intermediate threshold voltage distribution. In the first second program cycle of the second program operation, verify is first performed to select a portion of memory cells near the low tail from the intermediate threshold voltage distribution, and then the selected memory cells are programmed, while other memory cells in the intermediate threshold voltage distribution are not programmed. By appropriately increasing the threshold voltage of the memory cell in the low tail, the threshold voltage distribution can be effectively narrowed, so that the accuracy of data read-write is improved, and the influence of the IVS effect on the accuracy of data storage can be effectively reduced.

In some examples, the memory may perform in-memory operations. The in-memory operation refers to implementing a multiplication operation of the input data and the weight matrix in the memory to obtain a corresponding element in the output data. The input data may be an input matrix or an input vector composed of a plurality of elements.

The memory cell array may be configured to store a weight matrix when the memory performs in-memory operation phase, in an example, the weights in the weight matrix may be written into the memory cell array according to a certain mapping rule, and each memory cell in the memory cell array may be configured to store a weight. In the operation phase, the memory may receive input data from the controller, the input data may be an input matrix composed of a plurality of elements, and each element in the input data may be converted into an input voltage by the digital-to-analog conversion circuit shown in FIG. 2a or FIG. 2b, and the input voltage is input into the memory cell array by the bit line, the word line, or the selection line shown in FIG. 1. The select line may be one of the top select line 113 and the bottom select line 115.

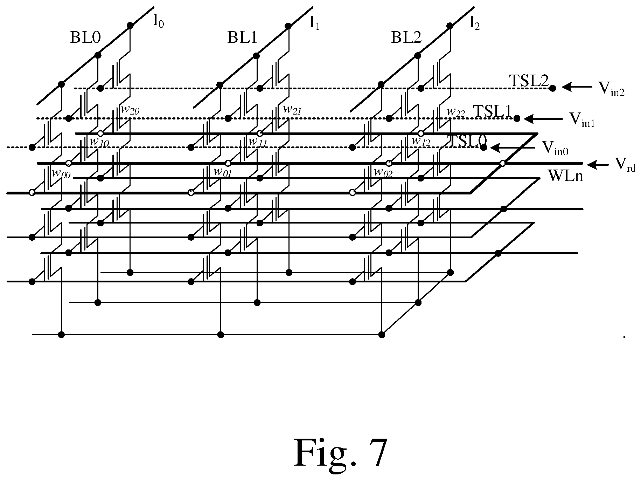

FIG. 7 is a schematic diagram of inputting an input voltage into a memory block by a top select line according to an example of the present disclosure. As shown in FIG. 7, the plurality of memory cells coupled to the selected word line WLn may be configured to store a plurality of weights in the weight matrix, in an example, the memory state corresponding to the threshold voltage of the memory cell may correspond to one weight.

The values of the plurality of elements in the input data are mapped to a plurality of input voltages, which are applied to the memory block by the respective plurality of top select lines. Each element in the output matrix is mapped to the current I of the bit line, and the current on the bit line corresponds to the result of the sum of the products of the plurality of input voltages and their corresponding weights. Taking FIG. 7 as an example, when the respective input voltages Vᵢₙ₀ , Vᵢₙ₁ and Vᵢₙ₂ are applied to the plurality of top select lines TSLO, TSL1, and TSL2, respectively, the current I₀ on the bit line BLO corresponds to a result of Vᵢₙ₀×w₀₀+ Vᵢₙ₁×w₁₀+ Vᵢₙ₂×w₂₀, the current I₁ on the bit line BL1 corresponds to a result of Vᵢₙ₀×w₀₁+ Vᵢₙ₁×w₁₁+ Vᵢₙ₂× w₂₁, and the current I₂ on the bit line BL2 corresponds to a result corresponding to Vᵢₙ₀ ×w₀₂+ Vᵢₙ₁×_{W12}+ Vᵢₙ₂×w₂₂.

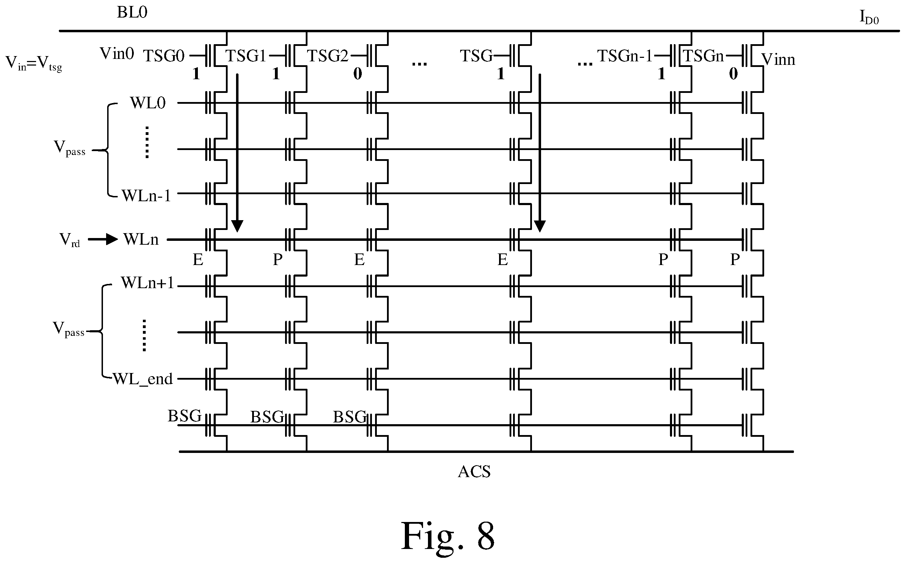

FIG. 8 is a schematic diagram of performing an in-memory operation on a memory cell array comprising a single-level cell according to an example of the present disclosure. FIG. 8 only takes a plurality of memory cell strings coupled to the same bit line BLO as an example to illustrate. As shown in FIG. 8, the value of any weight in the weight matrix is "1" or "0". The memory cell has an erased state and a programmed state. For example, the erased state E corresponds to the weight value "1", and the programmed state P corresponds to the weight value "0".

The input value in the input data is mapped to the input voltage Vᵢₙ, which is applied to the memory cell array by the top select line. An input value in the input data is "1" or "0", which may be mapped to a high level input voltage and a low level input voltage. The high level input voltage is greater than the threshold voltage of the top select gate TSG, such that the top select gate TSG is turned on, and the low level input voltage is less than the threshold voltage of the top select gate TSG, such that the top select gate TSG is turned off. For example, the high level input voltage corresponds to the input value "1", and the low level input voltage corresponds to the input value "0".

In the operation phase, a read voltage V_{rd} is applied to the selected word line WLn, a pass voltage Vₚₐₛₛ is applied to the non-selected word lines WLO~WLn -1 and WLn + 1~WL _ end, the corresponding input voltages Vᵢₙ₀ - Vᵢₙₙ are applied to a plurality of top select lines, that is, the gates of the plurality of top select gates TSG0-TSGn, respectively, and the current on the bit line BLO is sensed.

The read voltage V_{rd} is greater than the threshold voltage of the memory cell in the erased state E, and is less than the threshold voltage of the memory cell in the programmed state P. In other words, the read voltage V_{rd} is between the target threshold voltage distribution interval corresponding to the erased state E and the target threshold voltage distribution interval corresponding to the programmed state P, and it can distinguish whether the memory cell has the erased state E or the programmed state P. Applying a pass voltage Vₚₐₛₛ to the non-selected word lines coupled to the same memory block may cause the memory cells coupled to the non-selected word lines to be turned on, in which case the magnitude of the current in each memory string is only related to the threshold voltage, i.e., the memory state, of the memory cell coupled to the selected word line WLn.

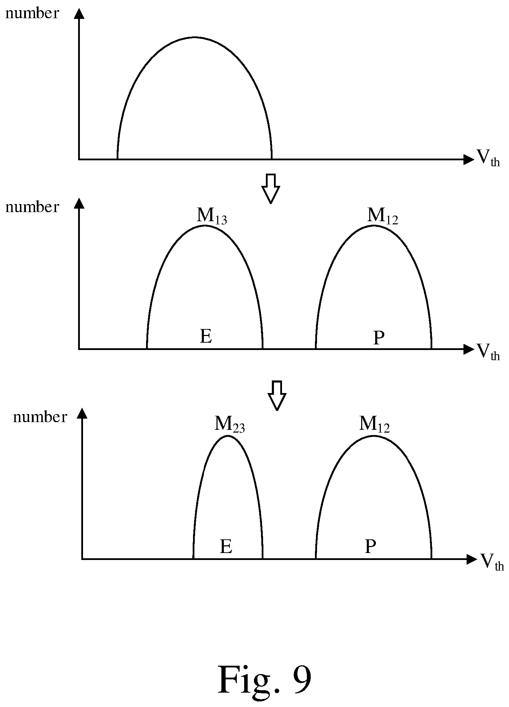

As shown in FIG. 9, when a high level input voltage (corresponding to input value "1") is applied to the top select line, such that the top select gate TSG is turned on, if the memory cell has the erased state E, the threshold voltage of the memory cell is less than the read voltage V_{rd} , so that the memory string to which the memory cell belongs is turned on and an obvious current is generated; if the memory cell has the programmed state P, the threshold voltage of the memory cell is greater than the read voltage V_{rd} , so that the memory string to which the memory cell belongs is turned off, and no obvious current is generated. Corresponding to the input value and the weight value, it can be understood as: when the input value is 1, if the weight value stored in the memory cell is 1 (corresponding to an erased state E), the memory string will generate a current; and when the input value is 1, if the weight value stored in the memory cell is 0 (corresponding to a programmed state P), the memory string will not generate current.

Similarly, when a low level input voltage (corresponding to input value "0") is applied to the top select line, the top select gate is turned off, and in this case, no matter the memory cell has the erased state E or the programmed state P, no current is generated in the memory string. Corresponding to the input value and the weight value, it can be understood as: when the input value is 0, no matter the weight value is 1 (corresponding to an erased state E) or 0 (corresponding to a programmed state P), no current is generated in the memory string. Based on this, it can be defined that, the memory string generating current corresponds to the output value being 1, and the memory string not generating current corresponds to the output value being 0. Then it can be understood that, when the input value is 1 and the weight value is 1, the output value is 1; when the input value is 1 and the weight value is 0, the output value is 0; when the input value is 0 and the weight value is 1, the output value is 0; when the input value is 0 and the weight value is 0, the output value is 0. This is consistent with the multiplication operation rule. Therefore, the input voltage can be applied to the memory cell array through the top select line, the weight value is stored through the memory cell, and the output value is obtained through the current of the bit line, thereby realizing the multiplication operation of the input vector and the weight matrix by using the memory array.

With continued reference to FIG. 9, when the respective input voltages Vᵢₙ₀ , Vᵢₙ₁ ··· Vᵢₙₙ are applied to a plurality of top select lines, that is, the gates of the plurality of top select gates TSGO, TSG1, ··· , to TSGn respectively, the current obtained on the bit line BLO is the sum of the currents of the plurality of memory strings, which corresponds to a result of the sum of the product of the plurality of input values Vᵢₙ₀, Vᵢₙ₁ ... Vᵢₙₙ and the corresponding weights *w₀₀*, *w₁₀*, *W₂₀*···*wₙ₁*. That is, the value corresponding to the current on the bit line is I_{D0} = Vᵢₙ₀ × w₀₀ + Vᵢₙ₁ × w₁₀ + ··· + Vᵢₙₙ × wₙ₀, and in this example, the current on the bit line is I_{D0} = 1 × 1 + 1 × 0 + 0 × 1 ... + 1 × 0 + 0 × 0.

As described above, in the in-memory operation phase, when the memory cell is in the erased state E, the memory string may output one current, and the bit line aggregates a plurality of currents output by a plurality of memory strings. With the increase of requirement on the computing power of the memory, the number of the memory strings coupled to the bit line continues to increase, and if the distribution of each current is wider, a calculation error may occur. For example, when the magnitude of N currents may be greater than the magnitude of N + 1 currents, the sum of N values may be equal to the sum of N + 1 values, resulting in a calculation error. Based on this, the examples of the present disclosure propose to narrow the threshold voltage distribution of the erased state E to narrow the distribution of each current, thereby improving the calculation accuracy.

In some examples, the target memory cell set is a memory cell set corresponding to the erased state E when the memory performs a write operation phase of the in-memory operation. First, a first program operation is performed on the memory cell set corresponding to the erased state E to adjust the threshold voltage of the memory cell in the memory cell set corresponding to the erased state E.

It may be understood that, in the memory cell set corresponding to the erased state E, the threshold voltage of the memory cell affects a magnitude of a current output by the memory string during the operation phase of the in-memory operation. Therefore, in this example, the first program operation is performed on the memory cell set corresponding to the erased state E, the threshold voltage of the memory cell in the erased state E may be changed, so that the magnitude of a current output by the memory string in the operation phase is changed. In other words, the first program operation may be performed on the memory cell corresponding to the erased state E to obtain a suitable threshold voltage according to the desired magnitude of each current.

After the first program operation, the threshold voltages of the memory cells in the memory cell set corresponding to the erased state E form an intermediate threshold voltage distribution of the erased state. Then, a second program operation is performed on the memory cell set corresponding to the erased state E, and in a first second program cycle of the second program operation, the memory cell set corresponding to the erased state E is verified first to select the memory cell failing to be verified, and then the memory cell failing to be verified is programmed, so that the threshold voltage of the memory cell failing to be verified moves to the direction of the threshold voltage increase (that is, to the right in the figure), and the threshold voltage distribution of the memory cell set can be narrowed, so that the threshold voltage distribution of the erased state E after the second program operation is narrower than the threshold voltage distribution of the first program operation. In this way, the magnitude of each current in the operation phase can be narrowed, thereby improving the accuracy of the in-memory operation.

It should be noted that, in general, when the memory performs data storage, the memory cell set corresponding to the erased state E is not required to be programmed. In this example, when the memory performs the in-memory operation, the threshold voltage distribution corresponding to the erased state E affects the accuracy of the calculation result, therefore, it is proposed to program the erased state E to narrow the threshold voltage distribution of the erased state E, and finally after a plurality of program operations, the threshold voltages of the memory cells in the memory cell set corresponding to the erased state E are programmed into the target threshold voltage distribution corresponding to the erased state E. The target threshold voltage distribution corresponding to the erased state E is the desired narrowed final threshold voltage distribution of the memory cell set corresponding to the erased state E.

In some examples, in the first program operation, only the memory cell set corresponding to the erased state E may be programmed. In some other examples, the first program operation may be performed simultaneously on the memory cell set corresponding to the erased state E and the memory cell set corresponding to the programmed state P.

FIG. 9 is a first schematic diagram of threshold voltage distribution of a memory cell coupled to a selected word line in a write operation phase of an in-memory operation according to an example of the present disclosure. In some examples, as shown in FIG. 9, the first program operation may be performed on the memory cell set corresponding to the erased state E, so that the threshold voltages of the memory cells in the memory cell set form the intermediate threshold voltage distribution M₁₃ corresponding to the programmed state E in FIG. 9. In addition, a first program operation is performed on the memory cell set corresponding to the programmed state P, so that the threshold voltage distribution of the memory cells in the memory cell set forms the intermediate threshold voltage distribution M₁₂ corresponding to the programmed state P in FIG. 9.

Next, a second program operation is performed on the memory cell set corresponding to the erased state E. In an example, the memory cell set corresponding to the erased state E is verified first in the first second program cycle, and then the memory cell failing to be verified is programmed to narrow the threshold voltage distribution. Here, the memory cell failing to be verified is a memory cell whose threshold voltage is less than the first preset threshold voltage in the memory cell set corresponding to the erased state. The first preset threshold voltage is related to the target threshold voltage distribution corresponding to the erased state.

For example, the first preset threshold voltage may be less than or equal to the lower limit value of the target threshold voltage distribution corresponding to the erased state. The second program operation may set the first preset threshold voltage to anywhere between the lower limit of the intermediate threshold voltage distribution M₁₃ of the erased state E and the lower limit value of the target threshold voltage distribution of the erased state E for different purposes.

As can be seen from FIG. 4 and FIG. 9, in different examples, the target memory cell set may be different memory cell sets, for example, in the example shown in FIG. 4, the target memory cell set is a memory cell set corresponding to the programmed state, and in this example, the target memory cell set is a memory cell set corresponding to the erased state. When the memory cell sets are different, the corresponding first preset threshold voltages are different. It can be understood that the first preset threshold voltage is related to the target threshold voltage distribution of the state corresponding to the target memory cell set, the first preset threshold voltage in the example shown in FIG. 4 is related to the target threshold voltage distribution of the programmed state, and the first preset threshold voltage in this example is related to the target threshold voltage distribution of the erased state, therefore, the first preset threshold voltage in the example shown in FIG. 4 is different from the first preset threshold voltage in this example.

As shown in FIG. 9, after the second program operation, the intermediate threshold voltage distribution M₂₃ corresponding to the erased state E is narrower than the intermediate threshold voltage distribution M₁₃ after the first program operation, which facilitates narrowing the current distribution of each current during the operation phase of the in-memory operation, thereby providing the accuracy of the in-memory operation.

In some examples, as shown in FIG. 9, in the write operation phase of the in-memory operation, the second program operation may not be performed on the memory cell set corresponding to the programmed state P. The threshold voltages of the memory cells in the memory cell set corresponding to the programmed state P still form an intermediate threshold voltage distribution M₁₂.

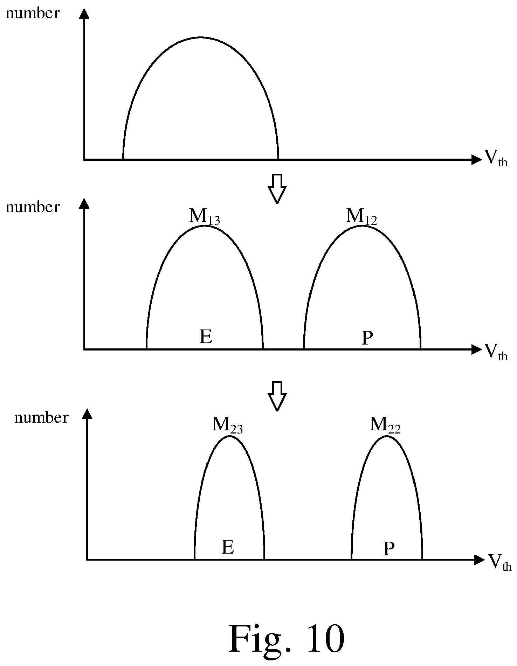

FIG. 10 is a second schematic diagram of threshold voltage distribution of a memory cell coupled to a selected word line in a write operation phase of an in-memory operation according to an example of the present disclosure. As shown in FIG. 10, in some examples, the peripheral circuit may be configured to: perform a second program operation on each memory cell set, and the second program operation performed on each memory cell set comprises at least one second program cycle; where the second program operation performed on any one of the memory cell sets comprises: performing a corresponding verify on at least a portion of the memory cell set during a verify phase of the second program cycle, and performing a corresponding programming on the memory cells failing to be verified during the program phase of the second program cycle.

For example, in the verify phase of the first second program cycle, the memory cell set (that is, all the memory cells in the memory cell set) is verified. In a verify phase of each of the other second program cycles except the first second program cycles, at least a portion of the memory cell set are verified. In the program phase of each second program cycle, memory cells failing to be verified during the verify phase in the same second program cycle are programmed.

It may be understood that when performing the corresponding verify on different memory cell sets, the voltages of the verify pulses used are different, and the voltage of the verify pulse is related to the corresponding first preset threshold voltage. The number of program cycles may be the same or different when performing corresponding program cycles on different memory cell sets. For example, the magnitudes of the voltages of the program pulses used in program cycles corresponding to different memory cell sets are different.

Compared with the example shown in FIG. 9, in this example, in addition to performing the second program operation on the memory cell set corresponding to the erased state E, the second program operation may be performed on the memory cell set corresponding to the programmed state P to narrow the intermediate threshold voltage distribution of the memory cell set corresponding to the programmed state P, to obtain the narrowed intermediate threshold voltage distribution M₂₂, so that the read window in the operation phase is increased, which facilitates improving the accuracy of the read result.

An example of the present disclosure further provides an in-memory operation method, and the peripheral circuit is configured to execute the in-memory operation method. In an example, the peripheral circuit is configured to: perform a first program operation on at least one or more memory cell sets corresponding to a programmed state of a plurality of memory cell sets coupled to a selected word line; where the memory cell set comprises a plurality of memory cells whose threshold voltages are to be programmed into a target threshold voltage distribution corresponding to a same programmed state or an erased state; perform a second program operation on the memory cell set corresponding to the erased state, where the second program operation comprises: at least one second program cycle comprising a verify phase and a program phase after the verify phase, where at least a portion of the memory cell set corresponding to the erased state are verified in the verify phase of the second program cycle, and the memory cells failing to be verified are programmed in the program phase of the second program cycle.

For example, in the verify phase of the first second program cycle, the memory cell set corresponding to the erased state (that is, all the memory cells in the memory cell set corresponding to the erased state) is verified. In the verify phase of each of the other second program cycles except the first second program cycle, at least a portion of the memory cell set corresponding to the erased state are verified. In the program phase of each second program cycle, memory cells failing to be verified during the verify phase in the same second program cycle are programmed.

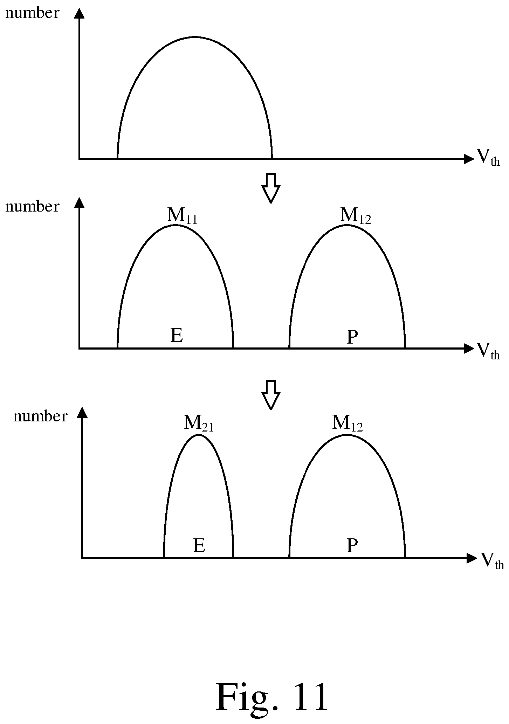

FIG. 11 is a third schematic diagram of threshold voltage distribution of a memory cell coupled to a selected word line in a write operation phase of an in-memory operation according to an example of the present disclosure. As shown in FIG. 11, firstly, a first program operation is performed on the memory cell set corresponding to the programmed state P, so that the memory cells in the memory cell set form the intermediate threshold voltage distribution M₁₂ corresponding to the programmed state P in FIG. 11. The memory cells in the memory cell set corresponding to the erased state E are not programmed, and their threshold voltages form the intermediate threshold voltage distribution M₁₁ corresponding to the erased state E.

Here, it should be noted that, if there are a plurality of programmed states, the first program operation may be performed simultaneously on a plurality of memory cell sets corresponding to the plurality of programmed states.

For example, the memory cell set corresponding to the programmed state P may be programmed with a larger program voltage to increase the read window between the intermediate threshold voltage distribution M₁₂ corresponding to the programmed state P and the initial threshold voltage distribution M₁₁ corresponding to the erased state E, so that even if the memory cells in the memory cell set corresponding to the programmed state causes the initial threshold distribution M₁₂ to shift to the left due to the IVS effect, it can be ensured that the read window meets the requirement.

Next, a second program operation is performed on the memory cell set corresponding to the erased state E. As shown in FIG. 11, after performing the second program operation on the memory cell set corresponding to the erased state E, the threshold voltage distribution M₂₁ corresponding to the erased state is narrower than the intermediate threshold voltage distribution M₁₁ after the first program operation.

In this example, in the write operation phase of the in-memory operation, the first program operation is performed on the memory cell set of the programmed state, so that the memory cell set corresponding to the programmed state and the memory cell set corresponding to the erased state each form an intermediate threshold voltage distribution. Then, a second program operation is performed on the memory cell set corresponding to the erased state, and verify is performed in the first second program cycle of the second program operation, and then the memory cell failing to be verified is programmed, so that the threshold voltage of the memory cell failing to be verified is appropriately increased, which facilitates narrowing the threshold voltage distribution of the erased state, thereby facilitating narrowing the current distribution of each current during the operation phase of the in-memory operation, and providing the accuracy of the in-memory operation.

In some examples, a second program operation may also be performed on the memory cell corresponding to the programmed state P to narrow the threshold voltage distribution of the programmed state.

In some examples, the peripheral circuit is configured to: inhibit to program the memory cells which pass verify in the program phase of each second program cycle.

Here, the memory cells which pass verify refers to memory cells with a threshold voltage greater than or equal to a first preset threshold voltage. In this example, in the program phase of each second program cycle, inhibiting to program the memory cells which pass verify can avoid the threshold voltages of the portion of memory cells becomes larger, which causes the upper limit value of the threshold voltage distribution to move to the direction of the high threshold voltage, resulting in that the threshold voltage distribution is widened again, and the over-program of the memory cell can also be reduced, thereby improving the program accuracy.

The present disclosure describes the processes of the first program operation and the second program operation in combination with several examples in detail.

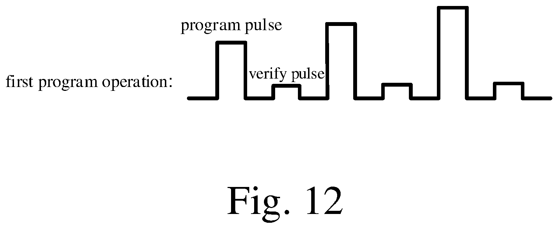

FIG. 12 is a first schematic diagram of a first program operation according to an example of the present disclosure. In some examples, as shown in FIG. 12, in a first program operation, a plurality of first program cycles may be performed using an incremental step pulse program (ISPP). In each first program cycle, a program pulse and a verify pulse are sequentially applied to the selected word line, where the verify pulse is after the program pulse.

The operation of performing the plurality of first program cycles by using the ISPP may refer to conventional ISPP operations in the art, which is not limited in the present disclosure. In the example shown in FIG. 4, taking the ISPP being employed to perform the plurality of first program cycles for the memory cell set corresponding to the programmed state P as an example to illustrate. As shown in FIG. 3, the first program cycle may be divided into a program phase and a verify phase after the program phase.

In the program phase, a program pulse is applied to a selected word line, a voltage of the program pulse is a program voltage; a program-pass voltage is applied to the unselected word line, a program voltage is applied to a bit line coupled to the memory cell set that is allowed to be programmed, and a program-inhibit voltage is applied to a bit line coupled to the memory cell set that is inhibited to be programmed. For the first first program cycle, the memory cells that are allowed to be programmed are all memory cells in the memory cell set corresponding to the programmed state P, and in other first program cycles except the first first program cycle, the memory cells that are allowed to be programmed are memory cells failing to be verified in the previous program cycle. The memory cells that are inhibited to be programmed comprise all memory cells in the memory cell set corresponding to the erased state E and memory cells passing the verification by the previous first program cycle.

For example, in the verify phase, a verify pulse is applied to the selected word line, and the page buffer coupled to all the memory cells in the memory cell set corresponding to the programmed state P senses the voltage change on the bit line, thereby verifying whether all the memory cells in the memory cell set corresponding to the programmed state P are successfully programmed in this program cycle. For example, after a preset number of first program cycles, the first program operation ends. Alternatively, after all memory cells in the memory cell set corresponding to the programmed state P pass verify, the first program operation ends.

As shown in FIG. 12, the voltages of the program pulses used in the plurality of first program cycles gradually increase, while the voltages of the verify pulses used may be the same.

In some examples, the steps of using the ISPP to perform the first program operation on the memory cell sets corresponding to the erased state E and the programmed state P may refer to the process of using the ISPP to program for the multilevel cell in the art, and details are not described herein again.

In some examples, when performing the first program operation on the memory cell set corresponding to the erased state E, the first program cycle comprises a verify phase and a program phase after the verify phase, where the target memory cell set is verified during the verify phase of the first first program cycle, and the memory cells failing to be verified are programmed in the program phase of the first program cycle. In each of the other first program cycles except the first program cycle, at least a portion of the memory cells in the target memory cell are verified and the memory cells failing to be verified are programmed in the program phase.

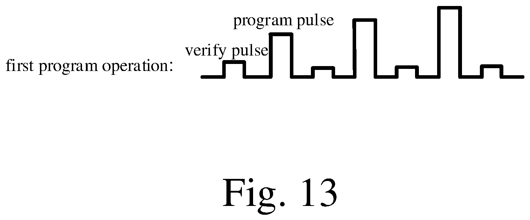

For example, as shown in FIG. 13, a verify pulse is applied to the selected word line in the verify phase of each first program cycle, and a program pulse is applied to the selected word line in the program phase of each first program cycle.

In this example, the steps of the first program operation and the second program operation performed on the memory cell set corresponding to the erased state E are the same, but the memory cells with the threshold voltage less than the second preset threshold voltage may be selected in the first first program cycle, the second preset threshold voltage is related to the target threshold voltage distribution corresponding to the erased state, and the second preset threshold voltage is different from the first preset threshold voltage. For example, the memory cell with the threshold voltage less than the second preset threshold voltage may be selected by setting the voltage of the verify pulse used in the first first program cycle or the sensing time.

In the first first program cycle of the first program operation, the erased state E is first verified and then programmed, the threshold voltage distribution corresponding to the erased state can be narrowed, meanwhile, the threshold voltage distribution of the erased state is ensured to be at a lower position, which facilitates increasing the read window between the threshold voltage distribution and the programmed state. Meanwhile, the read voltage applied to the selected word line in the operation phase is also reduced, so that the power consumption of the operation is reduced.

In some examples, in each of the other first program cycles after the first first program cycle, all memory cells in the memory cell set corresponding to the erased state E may be verified in the verify phase, and the memory cells failing to be verified are programmed in the program phase. The voltages of the verify pulses used in the plurality of first program cycles may be equal, or may not be equal. The voltage of the program pulse used in the plurality of first program cycles may gradually increase.

In some other examples, in each of the other first program cycles after the first first program cycle, the memory cells that have been programmed in the last first program cycle may be verified in the verify phase, and the memory cells failing to be verified may be programmed in the program phase. In this way, in the first program operation, only the selected memory cells failing to be verified in the first first program cycle are programmed, verified, reprogrammed, and the like, and the memory cells passing the verification in the first first program cycle are not programmed, and the threshold voltage distribution can be narrowed by programming the threshold voltages of the memory cells failing to be verified to proper magnitudes.

In some examples, at least in the verify phase of the first first program cycle, the memory cells in the memory cell set corresponding to the erased state E are verified to divide the memory cells in the memory cell set into a plurality of subsets according to the threshold voltages of the memory cells; and in the program phase of the first first program cycle, different subsets are programmed differently.

For example, programming different subsets differently comprises: applying a same bit line voltage to bit lines coupled to memory cells in the same subset, and applying different bit line voltages to bit lines coupled to memory cells in different subsets.

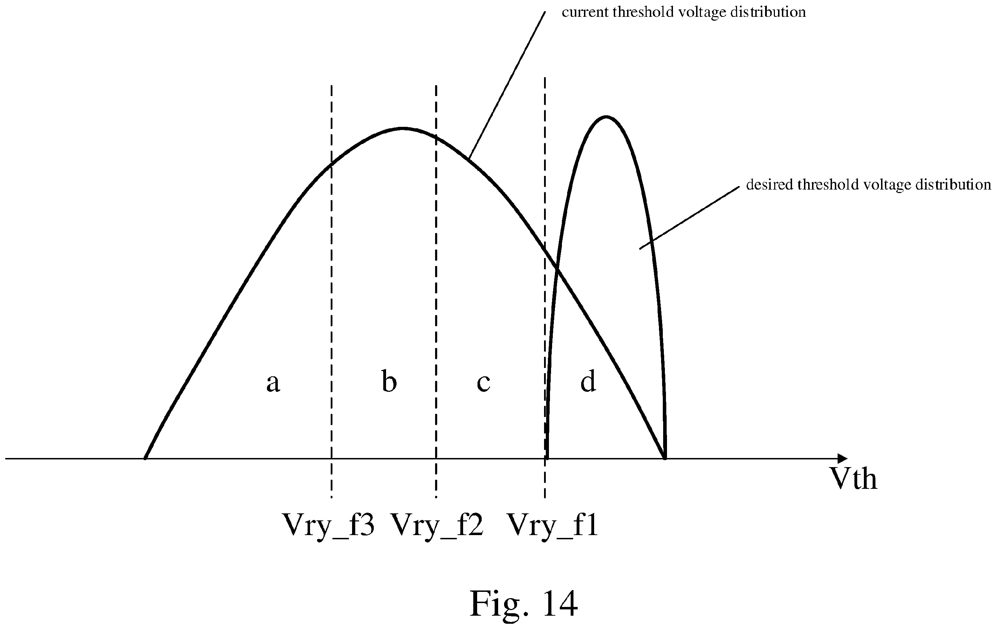

As shown in FIG. 14, when a threshold voltage of a certain memory cell in the memory cell set is verified to be greater than or equal to the first threshold voltage Vry _ f1, that is, when the threshold voltage of the memory cell is within the range d of the current threshold voltage distribution, it indicates that the current threshold voltage of the memory cell is larger, then the memory cell is inhibited from continuing to program, that is, a program-inhibit voltage (e.g.,VDD voltage) is applied to the bit line coupled to the memory cell.

When a threshold voltage of a certain memory cell is verified to be greater than or equal to the second threshold voltage Vry _ f2 and less than the first threshold voltage Vry _ f1, that is, the threshold voltage of the memory cell is within the range c of the current threshold voltage distribution. Considering that the threshold voltage distribution of the memory cell set is expected to converge within the range in which the threshold voltages are larger and the expected threshold voltage distribution is narrower, and in this case, the memory cell whose threshold voltage distribution of the memory cell is in the range c still needs to continue to be programmed, but the step size of this program needs to be shortened, preventing the program step length from being too long to cause the threshold voltage of the memory cell after the next program to exceed the range of the expected threshold voltage distribution. To shorten the step size of the next program, a first bit line forcing voltage Vmid1 is applied to the bit line coupled to the memory cell. The voltage value of Vmid1 is less than the VDD voltage and greater than the program-allow voltage. Here, the desired threshold voltage distribution is a threshold voltage distribution expected to obtain after the program phase in the program cycle.

When a threshold voltage of a certain memory cell is verified to be greater than or equal to the third threshold voltage Vry _ f3 and less than the second threshold voltage Vry _ f2, it indicates that the threshold voltage of the memory cell is programmed into the range b of the current threshold voltage distribution. Considering that the threshold voltage distribution of the memory cell is expected to converge within the range of the desired threshold voltage distribution, in this case, the memory cell having the threshold voltage distribution of the memory cell in the range b still needs to continue to be programmed, but the step size of this program needs to be shortened, preventing the step size of the program from being too long (for example, over-program) to cause the threshold voltage of the memory cell to exceed the range of the expected threshold voltage distribution after the next program; it will be understood that the step size of this program may be slightly greater than the step size used to program the memory cell whose current threshold voltage is in the range c. To shorten the step size of the next program, a second bit line forcing voltage Vmid2 is applied to the bit line coupled to the memory cell. The voltage value of Vmid2 is less than the Vmid1 voltage and greater than the program-allow voltage.

When a threshold voltage of a certain memory cell is verified to be less than the third threshold voltage Vry _ f3, it indicates that the threshold voltage of the memory cell is programmed to a range a of the current threshold voltage distribution, which is far from the desired threshold voltage distribution. It indicates that there is still a considerable distance from the desired threshold voltage distribution range expected to converge, and in this case, if Vmid2 or Vmid1 is used to program the memory cell, although the step size of program can be controlled, the program time can be increased, affecting the performance of the memory. Therefore, for a case where the threshold voltage is within the range a of the current threshold voltage distribution or has not been within the range a, a ground voltage, that is, a program-allow voltage, may be applied to a bit line of the memory cell.

In summary, in the verify phase, the memory cells in the memory cell set corresponding to the erased state are divided into a plurality of subsets, and for example, the plurality of subsets comprise a first subset, a second subset, a third subset and a fourth subset, which correspond to memory cells in the ranges a, b, c and d, respectively . In the program phase, the program-allow voltage, the second bit line forcing voltage, the first bit line forcing voltage, and the program-inhibit voltage are sequentially applied to the bit lines coupled to the memory cells within the first subset, the second subset, the third subset, and the fourth subset to program different subsets differently, thereby narrowing threshold voltage distribution better.

For example, in the verify phase, three sequentially increased verify voltages may be used to verify the memory cells in the memory cell set corresponding to the erased state E. Alternatively, one verify voltage and three different sensing times are used to verify to divide the memory cell set into the plurality of subsets described above.

Next, a process of performing the second program cycle in the second program operation is describe in detail.

In some examples, the second program operation comprises a plurality of second program cycles, each second program cycle comprises a verify phase and a program phase after the verify phase. For example, in the verify phase of each of the second program cycles, a verify pulse is applied to the selected word line, and in the program phase of each second program cycle, a program pulse is applied to the selected word line, and the program pulse is after the verify pulse.

The present disclosure takes a plurality of second program cycles being performed on the memory cell set corresponding to the programmed state P in the example shown in FIG. 4 as an example for illustration. In the verify phase of the first second program cycle, a verify pulse is applied to the selected word line, and the page buffer coupled to all the memory cells in the memory cell set corresponding to the programmed state P senses the voltage change on the bit line, so as to determine whether the memory cell passes verify. In the program phase of the first second program cycle, a program pulse is applied to the selected word line, a program-pass voltage is applied to the unselected word line, a program-allow voltage is applied to the bit line coupled to the memory cell set failing to be verified, and a program-inhibit voltage is applied to the bit line coupled to the memory cell set passing the verification.

In some examples, in each of the other second program cycles after the first second program cycle, all memory cells in the memory cell set corresponding to the programmed state P may be verified in the verify phase, and the memory cells failing to be verified are programmed in the program phase.

In other examples, in each of the other second program cycles after the first second program cycle, the memory cells that have been programmed in the last second program cycle may be verified in the verify phase, and the memory cells failing to be verified may be programmed in the program phase. That is, in the second program operation, the verify phase of the first second program cycle is to select a portion of the memory cells, and the other second program cycles after the first second program cycle are to program the threshold voltages of the portion of memory cells to the appropriate locations, while the memory cells passing the verification in the first second program cycle are not programmed, thereby narrowing the threshold voltage distribution.

The process of performing the second program operation on the memory cell set corresponding to the erased state E is the same as that described above, and details are not described herein again.

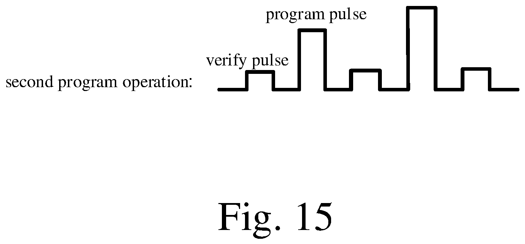

FIG. 15 is a first schematic diagram of a second program operation according to an example of the present disclosure. In some examples, as shown in FIG. 15, in the second program operation, the voltages of the program pulses used in the plurality of second program cycles gradually increase, and the voltages of the verify pulses used may be the same. In the present disclosure, the voltage of the program pulse is simply referred to as the program voltage Vpgm, and the voltage of the verify pulse is simply referred to as the verify voltage Vpv.

For example, at least one of a program voltage (Vpgm init) in a first second program cycle, an increment (ispp step) of program voltages in two adjacent second program cycles, a number of second program cycles, and a verify voltage may be adjusted. In an implementation, the control logic inside the memory may adjust these parameters. For example, the control logic may adjust these parameters according to the verify result in the previous second program cycle, the environmental parameter during the second program operation, the number of reads and writes of the memory cell when the current second program operation is performed, and the like. Of course, in further examples, these parameters may also be fixed, and cannot be adjusted after the memory leaves factory.

For example, in different implementations, at least one of a program voltage (Vpgm init) in a first second program cycle, an increment (ispp step) of program voltages in two adjacent second program cycles, a number of second program cycles, and a verify voltage may be different.

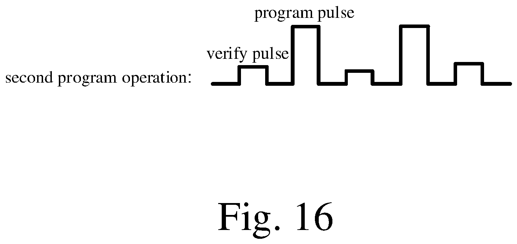

FIG. 16 is a second schematic diagram of a second program operation according to an example of the present disclosure. In some examples, as shown in FIG. 16, the second program operation comprises a plurality of second program cycles; a verify pulse is applied to the selected word line in the verify phase of each of the second program cycles, a program pulse is applied to the selected word line in the program phase of each of the second program cycles; where the voltages of the program pulses in the plurality of second program cycles are equal.

Compared to the example shown in FIG. 15, the difference lies in that the program voltages used in the plurality of second program cycles are fixed, but the magnitudes of the verify voltages are not all the same. For example, the program voltage may be set smaller, the threshold voltage of the selected memory cell may be programmed to the desired threshold voltage by increasing the number of program cycles, in this way, the probability of over-program is reduced.

For example, in two adjacent second program cycles, the verify voltage in the latter second program cycle may be greater than or less than the verify voltage in the former second program cycle. The control logic in the memory may adjust the verify voltage in the next second program cycle according to the verify result of the previous second program cycle.

For example, at least one of the program voltage in the second program cycle, the number of second program cycles, and the verify voltage in each second program cycle may be adjusted. For example, the control logic in the memory may adjust these parameters according to the verify result in the previous second program cycle, the environmental parameter during the second program operation, the number of reads and writes of the memory cell when the current second program operation is performed, and the like. Of course, in further examples, these parameters may also be fixed, and cannot be adjusted after the memory leaves factory.

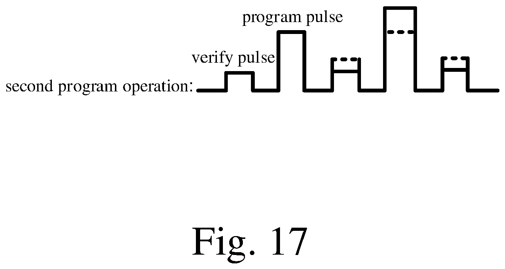

FIG. 17 is a third schematic diagram of a second program operation according to an example of the present disclosure. In some examples, as shown in FIG. 17, the second program operation comprises a plurality of second program cycles; a verify pulse is applied to the selected word line in the verify phase of each of the second program cycles, and a program pulse is applied to the selected word line in the program phase of each of the second program cycles; where the voltages of the program pulses in the two adjacent second program cycles are different, and / or the voltages of the verify pulses in the two adjacent second program cycles are different.

In other words, in any two adjacent second program cycles, the program voltage in the latter second program cycle may be different from the program voltage in the former second program cycle, or the verify voltage in the latter second program cycle may be different from the verify voltage in the former second program cycle, or both the program voltage and the verify voltage in the latter second program cycle may be different from the program voltage and the verify voltage in the former second program cycle.

In this example, when a subsequent second program cycle is performed, the program voltage and / or the verify voltage may be adjusted according to the result of the previous second program cycle, and the threshold voltage distribution may be narrowed to the greatest extent through the high-precision and dynamic adjustment.

In summary, the process of the plurality of second program cycles is not limited in the present disclosure, as long as the threshold voltage of the selected memory cell can be appropriately increased to narrow the threshold voltage distribution. In some examples, at least in the first second program cycle, the threshold voltage distribution may be narrowed by way of applying program-allow voltage, the first bit line forcing voltage, the second bit line forcing voltage, and the program-inhibit voltage to the bit lines coupled to the different subsets.

In some examples, the second program operation further comprises a verify step after the plurality of second program cycles for verifying whether the threshold voltage distribution of the memory cells in the memory cell set reaches a desired threshold voltage distribution after the second program operation.

For example, all memory cells in the target memory cell set may be verified in the verify step. An another example, if each of the other second program cycles except the first second program cycle verifies the memory cells that have been programmed in the previous second program cycle, the last verify step may also verify the memory cells that have been programmed in the last second program cycle.

In some examples, the peripheral circuit is further configured to: perform a third program operation on the target memory cell set, where the third program operation comprising: at least one third program cycle comprising a verify phase and a program phase after the verify phase, where at least a portion of the memory cells in the target memory cell set are verified in the verify phase of the third program cycle, and the memory cells failing to be verified are programmed in the program phase of the third program cycle.

For example, in the verify phase of the first third program cycle, the target memory cell set (that is, all memory cells in the target memory cell set) is verified. At least a portion of the memory cells in the target memory cell set are verified in the verify phase of each of the other third program cycles except the first third program cycle. In he program phase of each third program cycle, the memory cells failing to be verified in the verify phase in the same third program cycle are programmed.

The steps of performing the third program operation and the second program operation on the target memory cell set are the same, but the memory cell with the threshold voltage less than the third preset threshold voltage may be selected in the first third program cycle, the third preset threshold voltage is related to the target threshold voltage distribution corresponding to the erased state, and the third preset threshold voltage is different from the first preset threshold voltage and the second preset threshold voltage. For example, the memory cell with the threshold voltage less than the third preset threshold voltage may be selected by setting the voltage of the verify pulse used in the first third program cycle or the sensing time.

The process of the third program operation is the same as the second program operation, and details are not described herein again. However, it should be noted that the program voltage and the verify voltage used in the third program operation are not exactly the same as those in the second program operation. The third program operation enables the threshold voltage distribution of the target memory cell set to be closer to the target threshold voltage distribution.

In some examples, the peripheral circuit is configured to: inhibit performing the first program operation on other memory cell sets of the plurality of sets of memory cells when performing the first program operation phase on the target memory cell set; and inhibit performing the second program operation on the other memory cell sets during performing the second program operation on the target memory cell set.

In this example, a first program operation is performed on only one of the plurality of memory cell sets coupled to the selected word line at a time. If the first program operation needs to be performed on the plurality of memory cell sets, the first program operation is performed on one memory cell set before the first program operation is performed on the other memory cell set. Likewise, a second program operation is performed on only one of the plurality of memory cell sets at a time.

In some examples, the peripheral circuit is configured to: perform a respective first program operation on each of the other memory cells except the target memory cell set in the plurality of memory cell sets coupled to the selected word line; and
perform a respective second program operation on each of other memory cell sets.

For example, the second program operation is not performed on the memory cell set on which the second program operation needs to be performed, until the first program operation is performed on the memory cell set on which the first program operation needs to be performed in the plurality of memory cell sets coupled to the selected word line. For example, in the write operation phase of the in-memory operation, the first program operation may be continuously performed on the memory cell set corresponding to the erased state E and the memory cell set corresponding to the programmed state P, and then the second program operation is continuously performed on the memory cell set corresponding to the erased state E and the memory cell set corresponding to the programmed state P. After the respective first program operation has been completed on the memory cell set on which the first program operation needs to be performed in the plurality of memory cell sets coupled to the selected word line, and the respective second program operation has been completed on the memory cell set on which the second program operation needs to be performed, then the programming of all memory cells coupled to the selected word line has been completed.

In some examples, after all the first program operations are continuously performed on the plurality of memory cell sets coupled to the selected word line WLn + 1, all the second program operations are continuously performed on the plurality of memory cells coupled to the previous word line WLn, and all the first program operations are continuously performed on the plurality of memory cells coupled to the next word line WLn + 2. N is a positive integer greater than or equal to 0.

For example, after all the first program operations are continuously performed on the plurality of memory cell sets coupled to the first word line WL0, all the first program operations are continuously performed on the plurality of memory cell sets coupled to the second word line WL1, after all the second program operations are continuously performed on the plurality of memory cell sets coupled to the first word line WL0, all the first program operations are continuously performed on the plurality of memory cell sets coupled to the third word line WL2, all second program operations are performed on the plurality of memory cell sets coupled to the second word line WL1, and so on, until the data write is finished.

Herein, continuously performing all the first program operations on the plurality of memory cell sets coupled to the same word line means that the respective first program operation is continuously performed on the memory cell set on which the first program operation needs to be performed. Continuously performing all the second program operations on the plurality of memory cell sets coupled to the same word line means that the respective second program operation is continuously performed on the memory cell set on which the second program operation needs to be performed.

In some examples, the semiconductor device in the above example comprises a three-dimensional NAND type memory.

In some examples, the semiconductor device in the above example comprises a first semiconductor structure and a second semiconductor structure, the memory cell array is located in the first semiconductor structure, the peripheral circuit is located in the second semiconductor structure, and the first semiconductor structure and the second semiconductor structure are stacked along a thickness direction of the semiconductor device and coupled to each other. For example, the first semiconductor structure and the second semiconductor structure are bonded to each other to achieve an electrical connection.

In the examples of the present disclosure, the first semiconductor structure and the second semiconductor structure of the semiconductor device may be formed by bonding two wafers, for example, a first semiconductor structure may be formed on one wafer, a second semiconductor structure may be formed on the other wafer, and then the two wafers are bonded, the first semiconductor structure and the second semiconductor structure are stacked along a thickness direction of the semiconductor device, such a structure architecture can save the area of the semiconductor device and shorten the process cycle.

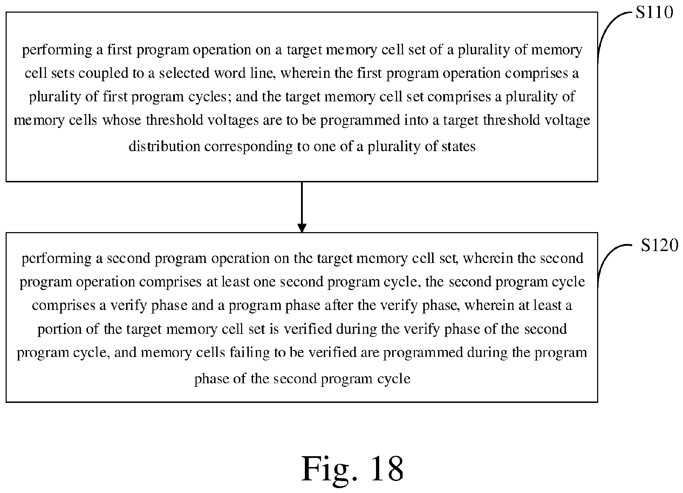

Based on a similar concept as the semiconductor device above, the present disclosure further provides an operating method of a semiconductor device, which may be performed by the semiconductor device according to any one of the above examples. FIG. 18 is a schematic flowchart of an operating method of a semiconductor device according to an example of the present disclosure, as shown in FIG. 18, the operating method comprises:

S110: performing a first program operation on a target memory cell set of a plurality of memory cell sets coupled to a selected word line, where the first program operation comprises a plurality of first program cycles; and the target memory cell set comprises a plurality of memory cells whose threshold voltages are to be programmed into a target threshold voltage distribution corresponding to one of a plurality of states; and

S210: performing a second program operation on the target memory cell set, where the second program operation comprises at least one second program cycle, the second program cycle comprises a verify phase and a program phase after the verify phase, where at least a portion of the target memory cell set are verified during the verify phase of the second program cycle, and memory cells failing to be verified are programmed during the program phase of the second program cycle.

In some examples, operation S210 further comprises: in a program phase in the second program cycle, inhibiting programming the memory cells passing the verify.

In some examples, operation S110 may be implemented by performing a plurality of first program cycles on the target memory cell set using an incremental step pulse program (ISPP).

In some examples, operation S210 may be implemented by performing a plurality of second program cycles on the target memory cell set, where a verify pulse is applied to the selected word line during the verify phase of each of the second program cycle, and a program pulse is applied to the selected word line during the program phase of each of the second program cycles; where voltages of the program pulses in the plurality of second program cycles are incremented.

In some examples, operation S210 may be implemented by performing a plurality of second program cycles on the target memory cell set, where a verify pulse is applied to the selected word line during the verify phase of each of the second program cycles, and a program pulse is applied to the selected word line during the program phase of each of the second program cycles; where voltages of the program pulses in the plurality of second program cycles are equal.

In some examples, operation S210 may be implemented by performing a plurality of second program cycles on the target memory cell set, where a verify pulse is applied to the selected word line during the verify phase of each of the second program cycles, and a program pulse is applied to the selected word line during the program phase of each of the second program cycles; wherein voltages of the program pulses in the two adjacent second program cycles are different, and / or the voltages of the verify pulses in the two adjacent second program cycles are different.

In some examples, the target memory cell set is a memory cell set corresponding to an erased state, and the step S110 may be implemented by performing a plurality of first program cycles on the target memory cell set, where each first program cycle comprising a verify phase and a program phase after the verify phase, where at least a portion of the target memory cell set are verified during the verify phase of the first program cycle, and the memory cells failing to be verified are programmed during the program phase of the program cycle.

In some examples, the target memory cell set is a memory cell set corresponding to an erased state, the first program cycle comprises a verify phase and a program phase after the verify phase, and step S110 may be implemented by verifying the target memory cell set during the verify phase of the first program cycle to divide the memory cells in the target memory cell set into a plurality of subsets according to the threshold voltages of the memory cells; and programming different subsets differently during the program phase of the first program cycle.

In some examples, the operating method further comprises: performing a third program operation on the target memory cell set, where the third program operation comprises at least one third program cycle, the third program cycle comprising a verify phase and a program phase after the verify phase, where at least a portion of the target memory cell set are verified during the verify phase of the third program cycle, and the memory cells failing to be verified are programmed during the program phase of the third program cycle.

In some examples, the operating method further comprises: inhibiting performing the first program operation on other memory cell sets of the plurality of memory cell set when performing the first program operation phase on the target memory cell set; and inhibiting performing the second program operation on the other memory cell set during performing the second program operation on the target memory cell set.

In some examples, the method further comprises: performing respective first program operation and second program operation on each of the other memory cell sets of the plurality of memory cell sets coupled to the selected word line.

In the operating method of the semiconductor device according to the present disclosure, in the write operation phase of the data storage, the target memory cell set may be the memory cell set corresponding to the programmed state, by performing the first program operation on the target memory cell set, the threshold voltage of the target memory cell set may form an intermediate threshold voltage distribution. In the first second program cycle of the second program operation, verify is first performed to select a portion of memory cells near the low tail from the intermediate threshold voltage distribution, and then the selected memory cells are programmed, while other memory cells in the intermediate threshold voltage distribution are not programmed. By appropriately increasing the threshold voltage of the memory cell in the low tail, the threshold voltage distribution can be effectively narrowed. In other second program cycles, the operating method of verify-before-program is also employed, and finally the threshold voltage distribution of the target memory cell set can be narrowed, so that the accuracy of data read-write is improved, and the influence of the IVS effect on the accuracy of data storage can be effectively reduced.

During the write operation phase of the in-memory operation, the target memory cell set may be the memory cell set corresponding to the erased state, and after the first program operation and the second program operation are performed on the target memory cell set, the threshold voltage distribution corresponding to the erased state may be narrowed, so that the magnitude of each current in the operation phase is narrowed, thereby improving the accuracy of the in-memory operation.

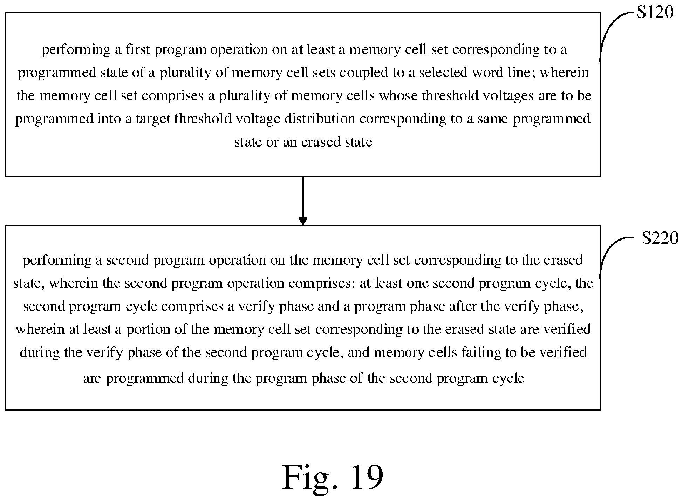

An example of the present disclosure further discloses an operating method of a semiconductor device, and FIG. 19 is a schematic flowchart of another operating method of a semiconductor device according to an example of the present disclosure, as shown in FIG. 19, the operating method comprises:
S120: performing a first program operation on at least a memory cell set corresponding to a programmed state of a plurality of memory cell sets coupled to a selected word line; where the memory cell set comprises a plurality of memory cells whose threshold voltages are to be programmed into a target threshold voltage distribution corresponding to a same programmed state or an erased state; and
S220: performing a second program operation on the memory cell set corresponding to the erased state, where the second program operation comprises: at least one second program cycle, the second program cycle comprises a verify phase and a program phase after the verify phase, where at least a portion of the memory cell set corresponding to the erased state are verified during the verify phase of the second program cycle, and memory cells failing to be verified are programmed during the program phase of the second program cycle.

In this example, after performing the second program operation on the memory cell set corresponding to the erased state in the write operation phase of the in-memory operation, the threshold voltage distribution corresponding to the erased state may be narrowed, so that the magnitude of each current in the operation phase is narrowed, thereby improving the accuracy of the in-memory operation.

Based on a similar concept as the semiconductor device above, the present disclosure further provides a system, comprising: at least one semiconductor device according to any one of the above examples, and a memory controller coupled to the semiconductor device and configured to control the semiconductor device.

In some examples, the memory controller is configured to send a weight matrix and an input matrix to the semiconductor device and to receive an operation result of the semiconductor device. Here, the operation result of the semiconductor device is an operation result obtained after the analog-to-digital conversion.

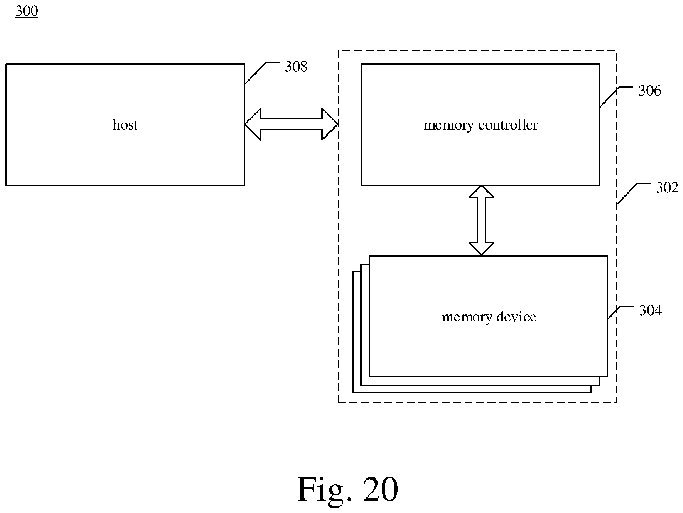

In some examples, the system in the above example may be the memory system 302 shown in FIG. 20, the memory system 302 comprises a memory controller 306 and a memory device 304 coupled to the memory controller 306, the controller in the above example may be the memory controller 306, and the semiconductor device may be the memory device 304. The memory controller 306 is coupled to the memory device 304 and the host 308 and is configured to control operations of the memory device 304, such as read, erase, program, compute operations. The memory controller 306 may manage data stored in the memory device 304 and communicate with the host 308.

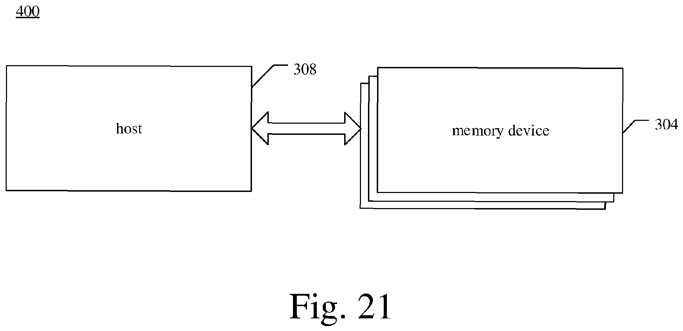

In some other examples, the system in the above example may be the system 400 shown in FIG. 21, the system 400 comprises a host 308 and a memory device 304 coupled to the host 308, and the controller in the above examples may be a CPU in the host-side device. The semiconductor device in the above example may be the memory device 304.

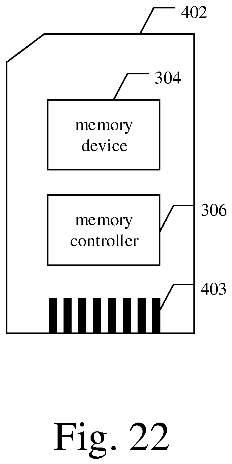

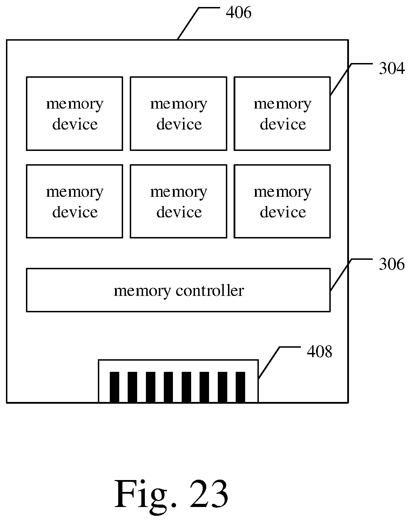

In one example as shown in FIG. 22, the system may be integrated into the memory card 402, the semiconductor device in the system may be the memory device 304 in the memory card 402, and the controller in the system may be the memory controller 306 in the memory card 402. The memory card 402 may be one of a compact flash memory card, a Smart Media Card (SMC), a Memory Stick (MS), a Multi-Media Card (MMC), for example, an RS-MMC, an MMCmicro, an eMMC, or the like, a secure digital card, for example, a Mini SD card, a Micro SD card, an SDHC card, or the like, and a universal flash memory card. The memory card 402 may also comprise a memory card connector 403 that couples the memory card 402 to the host. In another example as shown in FIG. 23, the system may be integrated into a Solid State Disk (SSD) 406, the semiconductor device in the system may be the memory device 304 in the solid state disk 406, and the memory controller in the system may be the memory controller 306 in the solid state disk 406. The solid state disk 406 may further comprise a solid state disk connector 408 that couples the solid state disk 406 to the host-side device. In some implementations, the storage capacity and / or operating speed of the solid state disk 406 is greater than the storage capacity and / or the operating speed of the memory card 402.

In some other examples, the system may be integrated in the terminal device, the memory controller may be a Central Processing Unit (CPU) of the terminal device, and the terminal device may comprise, but is not limited to, a mobile phone, a smart television, a smart speaker, a wearable device, a tablet computer, a desktop computer, a computer integrated machine, a handheld computer, a notebook computer, a server, an Ultra-Mobile Personal Computer (UMPC), a netbook, a Personal Digital Assistant (PDA), a laptop, a mobile computer, an Augmented Reality (AR) device, a Virtual Reality (VR) device, an Artificial Intelligence (AI) device, or any terminal device or a portable terminal device.

It should be understood that the system comprises, but is not limited to, a memory system. For example, the system may comprise a memory system and a memory computing system, for example, a compute-in-memory system comprising a memory system and a processor, where the processor comprises at least one of a CPU, a GPU, or an NPU. In an implementation, the system may be a compute-in-memory SoC (system on chip).

The features disclosed in the several device examples according to the present disclosure may be arbitrarily combined without conflict, to obtain a new device example.

The methods disclosed in the several method examples according to the present disclosure may be arbitrarily combined without conflict, to obtain a new method example.

The above descriptions are only specific implementations of the present disclosure, but the protection scope of the present disclosure is not limited thereto, and changes or replacements that may be easily conceived by any person skilled in the art within the technical scope of the present disclosure should be covered within the protection scope of the present disclosure.

## Claims

1. A semiconductor device, comprising:
a memory cell array;
word lines coupled to the memory cell array; and
a peripheral circuit coupled to the word lines and configured to:
perform a first program operation on a target memory cell set of a plurality of memory cell sets coupled to a selected word line, wherein the first program operation comprises a plurality of first program cycles, and the target memory cell set comprises a plurality of memory cells whose threshold voltages are to be programmed into a target threshold voltage distribution corresponding to one of a plurality of states; and
perform a second program operation on the target memory cell set, wherein the second program operation comprises at least one second program cycle, the second program cycle comprises a verify phase and a program phase after the verify phase, wherein at least a portion of the target memory cell set is verified during the verify phase of the second program cycle, and memory cells failing to be verified are programmed during the program phase of the second program cycle.

2. The semiconductor device of claim 1, wherein the peripheral circuit is configured to:
inhibit programming the memory cells passing the verification during the program phase of the second program cycle.

3. The semiconductor device of claim 1 or 2, wherein the plurality of state comprises an erased state and at least one programmed state; and
wherein the threshold voltage of a memory cell of the target memory cell set is to be programmed into the target threshold voltage distribution corresponding to the erased state.

4. The semiconductor device of claim 1, wherein in the first program operation, the plurality of first program cycles are performed with an incremental step pulse program (ISPP).

5. The semiconductor device of claim 1, wherein the second program operation comprises a plurality of second program cycles; and
a verify pulse is applied to the selected word line during the verify phase of each of the second program cycles, and a program pulse is applied to the selected word line during the program phase of each of the second program cycles, wherein voltages of the program pulses in the plurality of second program cycles are incremented.

6. The semiconductor device of claim 1, wherein the second program operation comprises a plurality of second program cycles; and
a verify pulse is applied to the selected word line during the verify phase of each of the second program cycles, and a program pulse is applied to the selected word line during the program phase of each of the second program cycles, wherein voltages of the program pulses in the plurality of second program cycles are equal.

7. The semiconductor device of claim 1, wherein the second program operation comprises a plurality of second program cycles; and
a verify pulse is applied to the selected word line during the verify phase of each of the second program cycles, and a program pulse is applied to the selected word line during the program phase of each of the second program cycles,
wherein at least one of:
voltages of the program pulses in two adjacent second program cycles are different, or
voltages of the verify pulses in two adjacent second program cycles are different.

8. The semiconductor device of claim 1, wherein a threshold voltage of a memory cell in the target memory cell set is to be programmed into a target threshold voltage distribution corresponding to an erased state; and
the first program cycle comprises a verify phase and a program phase after the verify phase, and the peripheral circuit is configured to: verify at least a portion of the target memory cell set during the verify phase of the first program cycle, and program memory cells failing to be verified during the program phase of the first program cycle.

9. The semiconductor device of claim 1, wherein a threshold voltage of a memory cell in the target memory cell set is programmed into a target threshold voltage distribution corresponding to an erased state; and
the first program cycle comprises a verify phase and a program phase after the verify phase, and the peripheral circuit is configured to: verify the target memory cell set during the verify phase of the first program cycle to divide memory cells in the target memory cell set into a plurality of subsets according to the threshold voltages of the memory cells; and program different subsets differently during the program phase of the first program cycle.

10. The semiconductor device of claim 1, wherein the peripheral circuit is configured to:
perform a third program operation on the target memory cell set, wherein the third program operation comprises at least one third program cycle, the third program cycle comprising a verify phase and a program phase after the verify phase, wherein at least a portion of the target memory cell set is verified during the verify phase of the third program cycle, and the memory cells failing to be verified are programmed during the program phase of the third program cycle.

11. The semiconductor device of claim 1, wherein the peripheral circuit is configured to:
inhibit performing a respective first program operation on other memory cell sets of the plurality of memory cell sets during performing the first program operation on the target memory cell set; and
inhibit performing a respective second program operation on the other memory cell sets during performing the second program operation on the target memory cell set.

12. The semiconductor device of claim 11, wherein the peripheral circuit is configured to:
perform a respective first program operation on each of other memory cell sets except the target memory cell set in the plurality of memory cell sets coupled to the selected word line; and
perform a respective second program operation on each of the other memory cell sets.

13. The semiconductor device of claim 1, wherein the second program operation further comprises a verify operation after a plurality of second program cycles; and
the peripheral circuit is configured to: verify at least a portion of the target memory cell set during the verify operation.

14. The semiconductor device of claim 1, further comprising: bit lines coupled to the memory cell array, wherein
the peripheral circuit comprises a control logic, an analog-to-digital conversion circuit, a digital-to-analog conversion circuit and a digital circuit, wherein the analog-to-digital conversion circuit is coupled to the bit lines, the digital circuit is coupled to the control logic through the digital-to-analog conversion circuit, and the digital circuit is further coupled to the analog-to-digital conversion circuit.

15. The semiconductor device of claim 1, wherein the semiconductor device comprises a three-dimensional NAND type memory.

16. The semiconductor device of claim 1, wherein the semiconductor device comprises a first semiconductor structure and a second semiconductor structure; the memory cell array is located in the first semiconductor structure, the peripheral circuit is located in the second semiconductor structure, and the first semiconductor structure is hybrid bonded to the second semiconductor structure.

17. A semiconductor device, comprising:
a memory cell array;
word lines coupled to the memory cell array; and
a peripheral circuit coupled to the word lines and configured to:
perform a first program operation on at least a memory cell set corresponding to a programmed state in a plurality of memory cell sets coupled to a selected word line, wherein the memory cell set comprises a plurality of memory cells whose threshold voltages are to be programmed into a target threshold voltage distribution corresponding to a same programmed state or an erased state; and
perform a second program operation on the memory cell set corresponding to the erased state, wherein the second program operation comprises at least one second program cycle, the second program cycle comprises a verify phase and a program phase after the verify phase, wherein at least a portion of the memory cell set corresponding to the erased state is verified during the verify phase of the second program cycle, and memory cells failing to be verified are programmed during the program phase of the second program cycle.

18. A system, comprising:
one or more semiconductor devices as claimed in any one of claims 1 to 17; and
a memory controller coupled to the semiconductor device and configured to control the semiconductor device.

19. An operating method of a semiconductor device, comprising:
performing a first program operation on a target memory cell set of a plurality of memory cell sets coupled to a selected word line, wherein the first program operation comprises a plurality of first program cycles, and the target memory cell set comprises a plurality of memory cells whose threshold voltages are to be programmed into a target threshold voltage distribution corresponding to one of a plurality of states; and
performing a second program operation on the target memory cell set, wherein the second program operation comprises at least one second program cycle, the second program cycle comprises a verify phase and a program phase after the verify phase, wherein at least a portion of the target memory cell set is verified during the verify phase of the second program cycle, and memory cells failing to be verified are programmed during the program phase of the second program cycle.

20. The operating method of claim 19, wherein the performing a second program operation on the target memory cell set comprises:
inhibiting programming the memory cells passing the verification during the program phase of the second program cycle,.

21. The method of claim 19, wherein the performing a first program operation on a target memory cell set of a plurality of memory cell sets coupled to a selected word line comprises:
for the first program operation comprising a plurality of first program cycles, performing the plurality of first program cycles on the target memory cell set with an incremental step pulse program (ISPP).

22. The operating method of claim 19, wherein the performing a second program operation on the target memory cell set comprises:
performing a plurality of second program cycles on the target memory cell set, wherein a verify pulse is applied to the selected word line during the verify phase of each of the second program cycles, and a program pulse is applied to the selected word line during the program phase of each of the second program cycles, wherein voltages of the program pulses in the plurality of second program cycles are incremented.

23. The operating method of claim 19, wherein the performing a second program operation on the target memory cell set comprises:
performing a plurality of second program cycles on the target memory cell set, wherein a verify pulse is applied to the selected word line during the verify phase of each of the second program cycles, and a program pulse is applied to the selected word line during the program phase of each of the second program cycles, wherein voltages of the program pulses in the plurality of second program cycles are equal.

24. The operating method of claim 19, wherein the performing a second program operation on the target memory cell set comprises:
performing a plurality of second program cycles on the target memory cell set, wherein a verify pulse is applied to the selected word line during the verify phase of each of the second program cycles, and a program pulse is applied to the selected word line during the program phase of each of the second program cycles,
wherein at least one of:
voltages of the program pulses in two adjacent second program cycles are different, or
voltages of the verify pulses in two adjacent second program cycles are different.

25. The operating method of claim 19, wherein a threshold voltage of a memory cell in the target memory cell set is to be programmed into a target threshold voltage distribution corresponding to an erased state; and
the performing a first program operation on a target memory cell set in a plurality of memory cell sets coupled to a selected word line comprises:
performing a plurality of first program cycles on the target memory cell set, wherein each of the first program cycles comprises a verify phase and a program phase after the verify phase, wherein at least a portion of the target memory cell set is verified during the verify phase of the first program cycle, and the memory cells failing to be verified are programmed during the program phase of the first program cycle.

26. The operating method of claim 19, further comprising:
performing a third program operation on the target memory cell set, wherein the third program operation comprises at least one third program cycle, the third program cycle comprising a verify phase and a program phase after the verify phase, wherein at least a portion of the target memory cell set is verified during the verify phase of the third program cycle, and the memory cells failing to be verified are programmed during the program phase of the third program cycle.

27. The operating method of claim 19, further comprising:
inhibiting performing a respective first program operation on other memory cell sets of the plurality of memory cell sets during performing the first program operation on the target memory cell set; and
inhibiting performing a respective second program operation on the other memory cell sets during performing the second program operation on the target memory cell set.

28. The operating method of claim 19, further comprising:
performing a respective first program operation on each of other memory cell sets except the target memory cell set in the plurality of memory cell sets coupled to the selected word line; and
performing a respective second program operation on each of the other memory cell sets.

29. An operating method of a semiconductor device, comprising:
performing a first program operation on at least a memory cell set corresponding to a programmed state in a plurality of memory cell sets coupled to a selected word line, wherein the memory cell set comprises a plurality of memory cells whose threshold voltages are to be programmed into a target threshold voltage distribution corresponding to a same programmed state or an erased state; and
performing a second program operation on the memory cell set corresponding to the erased state, wherein the second program operation comprises at least one second program cycle, the second program cycle comprises a verify phase and a program phase after the verify phase, wherein at least a portion of the memory cell set corresponding to the erased state is verified during the verify phase of the second program cycle, and memory cells failing to be verified are programmed during the program phase of the second program cycle.
